# EUROPEAN PATENT APPLICATION

(11) **EP 4 503 131 A1**
(43) Date of publication of application: **05.02.2025**
(21) Application number: 24181048.0
(22) Date of filing: 10.06.2024
(51) Int. Cl.: H01L 27/146

(54) **IMAGE SENSOR HAVING NANO-PHOTONIC LENS ARRAY AND ELECTRONIC APPARATUS INCLUDING THE IMAGE SENSOR**

(30) Priority: 31.07.2023 KR 20230100043
(71) Applicant: Samsung Electronics Co., Ltd., Suwon-si, Gyeonggi-do 16677 (KR)
(72) Inventor: CHO, Choonlae, 16678 Suwon-si (KR); PARK, Hongkyu, 16678 Suwon-si (KR); CHA, Jungho, 16678 Suwon-si (KR); ROH, Sookyoung, 16678 Suwon-si (KR); MUN, Sangeun, 16678 Suwon-si (KR); AHN, Sungmo, 16678 Suwon-si (KR)
(74) Representative: Elkington and Fife LLP

(57) **Abstract**

Provided is an image sensor including a sensor substrate including a plurality of pixels configured to sense light, and a nano-photonic lens array configured to separate incident light based on color and condense the separated incident light onto the plurality of pixels, wherein the nano-photonic lens array includes a plurality of supercells two-dimensionally disposed and including first unit patterns and second unit patterns, respectively including a plurality of pixel corresponding regions corresponding to the plurality of pixels, and wherein each of the plurality of pixel corresponding regions includes a plurality of nano-structures configured to separate the incident light based on color and condense the incident light onto the plurality of pixels, and wherein a cross-sectional size or a cross-sectional shape of a first nano-structure is different from a cross-sectional size or a cross-sectional shape of a second nano-structure.

## Description

### FIELD OF THE INVENTION

Embodiments of the present disclosure relate to an image sensor including a nano-photonic lens array and an electronic apparatus including the image sensor.

### BACKGROUND OF THE INVENTION

Image sensors generally sense the color of incident light by using a color filter. However, a color filter may have low light utilization efficiency because the color filter absorbs light of colors other than the intended color of light. For example, in the case in which a red-green-blue (RGB) color filter is used, only 1/3 of the incident light is transmitted therethrough and the other part of the incident light, that is, 2/3 of the incident light, is absorbed. Thus, the light utilization efficiency is only about 33%. Thus, in a color display apparatus or a color image sensor, most light loss occurs in the color filter.

### SUMMARY OF THE INVENTION

One or more example embodiments provide an image sensor including a nano-photonic lens array and having an improved optical efficiency, and an electronic apparatus including the image sensor.

One or more example embodiments also provide a nano-photonic lens array configured to reduce pattern artifacts occurring in an image at a boundary portion where cross-sectional sizes and/or shapes of nano-structures vary.

Additional aspects will be set forth in part in the description which follows and, in part, will be apparent from the description, or may be learned by practice of the presented embodiments of the disclosure.

According to an aspect of an example embodiment, there is provided an image sensor including a sensor substrate including a plurality of pixels configured to sense light, and a nano-photonic lens array configured to separate incident light based on color and condense the separated incident light onto the plurality of pixels, wherein the nano-photonic lens array includes a plurality of supercells that are periodically two-dimensionally disposed, the plurality of supercells including first unit patterns and second unit patterns, and the first unit patterns and the second unit patterns respectively including a plurality of pixel corresponding regions corresponding to the plurality of pixels, wherein each of the plurality of pixel corresponding regions includes a plurality of nano-structures configured to separate the incident light based on color and condense the incident light onto the plurality of pixels, and wherein a cross-sectional size or a cross-sectional shape of a first nano-structure among the plurality of nano-structures included in the first unit patterns is different from a cross-sectional size or a cross-sectional shape of a second nano-structure, among the plurality of nano-structures in the second unit pattern, at a position corresponding to the first nano-structure.

A first cross-sectional size of the first nano-structure included in the first unit pattern may be different from a second cross-sectional size of the second nano-structure included in the second unit pattern.

The first cross-sectional size and the second cross-sectional size may be integer multiples of a minimum unit size.

The nano-photonic lens array may include a first section, a second section, and a third section between the first section and the second section, and the first section may include the first unit patterns, the second section may include the second unit patterns, and the third section may include the plurality of supercells.

In each of the plurality of supercells, the first unit patterns, and the second unit patterns may be in an NxM array, where at least one of N and M is an integer greater than or equal to 2.

The nano-photonic lens array may further include a fourth section between the third section and the second section, wherein the plurality of supercells may include a plurality of first supercells periodically two-dimensionally disposed in the third section and a plurality of second supercells periodically two-dimensionally disposed in the fourth section, and wherein a ratio between the first unit patterns and the second unit patterns included in each of the plurality of first supercells may be different from a ratio between the first unit patterns and the second unit patterns in each of the plurality of second supercells.

The first section, the second section, the third section, and the fourth section may be disposed in concentric circles.

In each of the plurality of first supercells and the plurality of second supercells, the first unit patterns and the second unit patterns may be disposed in a 2x2 array, and wherein each of the plurality of first supercells may include three first unit patterns and one second unit pattern, and each of the plurality of second supercells may include two first unit patterns and two second unit patterns.

The plurality of first supercells included in the third section may comprise a first array and a second array, wherein the arrangement of the first unit patterns and the second unit patterns in the first array may be different from the arrangement of the first unit patterns and the second unit patterns in the second array, and the plurality of second supercells included in the fourth section may comprise a third array and a fourth array, wherein the arrangement of the first unit patterns and the second unit patterns in the third array may be different from the arrangement of the first unit patterns and the second unit patterns in the fourth array.

The nano-photonic lens array may further include a fifth section between the fourth section and the second section, wherein the plurality of supercells may include a plurality of third supercells periodically and two-dimensionally disposed in the fifth section, and wherein a ratio between the first unit patterns and the second unit patterns in each of the plurality of third supercells may be different from the ratio between the first unit patterns and the second unit patterns in each of the plurality of first supercells and each of the plurality of second supercells.

A ratio of the first unit patterns may be reduced and a ratio of the second unit patterns may be increased sequentially from the first section to the third section, the fourth section, the fifth section, and the second section.

In each of the plurality of first supercells, the plurality of second supercells, and the plurality of third supercells, the first unit patterns and the second unit patterns may be disposed in a 2x2 array, and wherein each of the plurality of first supercells may include three first unit patterns and one second unit pattern, each of the plurality of second supercells may include two first unit patterns and two second unit patterns, and each of the plurality of third supercells may include one first unit pattern and three second unit patterns.

The plurality of supercells in at least one of the third section, the fourth section, and the fifth section respectively may include a plurality of unit patterns disposed in an N1xM1 array, the plurality of supercells in at least a section different from the third section, the fourth section, and the fifth section respectively may include a plurality of unit patterns disposed in an N2xM2 array, where N1 and N2 are positive integers that are different from each other or M1 and M2 are positive integers that are different from each other.

The first unit patterns and the second unit patterns may include third nano-structures having cross-sectional sizes or cross-sectional shapes that are equal to or different from the cross-sectional sizes or cross-sectional shapes of the first nano-structures and the second nano-structures.

The nano-photonic lens array may further include fourth nano-structures having cross-sectional sizes or cross-sectional shapes that are equal to or different from the cross-sectional sizes or the cross-sectional shapes of the first nano-structures and second nano-structures and are different from the cross-sectional sizes or the cross-sectional shapes of the third nano-structures.

A first cross-sectional size of the first nano-structure may be different from a second cross-sectional size of the second nano-structure, and a third cross-sectional size of the third nano-structure may be equal to or different from the first cross-sectional size and the second cross-sectional size and a fourth cross-sectional size of the fourth nano-structure may be equal to or different from the first cross-sectional size and the second cross-sectional size and different from the third cross-sectional size.

The nano-photonic lens array may further include third unit patterns and fourth unit patterns, the third unit patterns respectively includes the first nano-structures and the fourth nano-structures, and the fourth unit patterns respectively includes the second nano-structure and the fourth nano-structure.

The nano-photonic lens array may further include a plurality of supercells in which unit patterns selected from the first unit patterns, the second unit patterns, the third unit patterns, and the fourth unit patterns may be arranged in an NxM array, where at least one of N and M is an integer greater than or equal to 2.

The plurality of pixels may include a plurality of unit pixel patterns respectively including a first pixel, a second pixel, a third pixel, and a fourth pixel, the plurality of pixel corresponding regions included in each of the first unit patterns and the second unit patterns may include a first pixel corresponding region corresponding to the first pixel, a second pixel corresponding region corresponding to the second pixel, a third pixel corresponding region corresponding to the third pixel, and a fourth pixel corresponding region corresponding to the fourth pixel, and a cross-sectional size, a cross-sectional shape, and a height of each of the plurality of nano-structures and an arrangement period and an arrangement shape of the plurality of nano-structures may be determined such that, in incident light incident on the first pixel corresponding region, the second pixel corresponding region, the third pixel corresponding region, and the fourth pixel corresponding region, light of a first wavelength band is separated and condensed onto the first pixel, light of a second wavelength band different from the first wavelength band is separated and condensed onto the second pixel and the third pixel, and light of a third wavelength band different from the first wavelength band and the second wavelength band is separated and condensed onto the fourth pixel.

According to another aspect of an example embodiment, there is provided an electronic apparatus including a lens assembly configured to form an optical image of a subject, an image sensor configured to convert the optical image formed by the lens assembly into an electrical signal, and a processor configured to process a signal generated by the image sensor, wherein the image sensor may include a sensor substrate including a plurality of pixels configured to sense light, and a nano-photonic lens array configured to separate incident light based on color and condense the separated incident light onto the plurality of pixels, wherein the nano-photonic lens array includes a plurality of supercells that are periodically two-dimensionally disposed, the plurality of supercells including first unit patterns and second unit patterns, and the first unit patterns and the second unit patterns respectively including a plurality of pixel corresponding regions corresponding to the plurality of pixels, wherein each of the plurality of pixel corresponding regions includes a plurality of nano-structures configured to separate the incident light based on color and condense the incident light onto the plurality of pixels, and wherein a cross-sectional size or a cross-sectional shape of a first nano-structure among the plurality of nano-structures included in the first unit pattern may be different from a cross-sectional size or a cross-sectional shape of a second nano-structure, among the plurality of nano-structures included in the second unit pattern, at a position corresponding to the first nano-structure.

### BRIEF DESCRIPTION OF THE DRAWINGS

The above and other aspects, features, and advantages of example embodiments of the disclosure will be more apparent from the following description taken in conjunction with the accompanying drawings, in which:
FIG. 1 is a schematic block diagram of an image sensor according to an embodiment;
FIGS. 2A, 2B, and 2C are diagrams showing examples of various pixel arrangements in a pixel array of an image sensor;
FIGS. 3A and 3B are cross-sectional views schematically showing a structure of a pixel array in an image sensor according to an example embodiment;
FIG. 4 is a plan view schematically showing a structure of a sensor substrate in the pixel array of FIGS. 3A and 3B;
FIG. 5 is a plan view schematically showing a structure of a color filter layer of FIGS. 3A and 3B;
FIG. 6 is a plan view showing an example of a unit pattern in the nano-photonic lens array of FIGS. 3A and 3B;
FIG. 7 is a diagram showing an example of phase profiles of blue light and green light after passing through the nano-photonic lens array of FIG. 6;
FIG. 8 is a diagram showing an example of phase profiles of green light and red light after passing through the nano-photonic lens array of FIG. 6;
FIG. 9 is a diagram showing an example of an arrangement of unit patterns having nano-structures of different cross-sectional sizes in a nano-photonic lens array;
FIGS. 10 and 11 are plan views showing examples of unit patterns having nano-structures with different cross-sectional sizes;
FIG. 12 is a plan view showing an example of one supercell structure including a plurality of unit patterns in the nano-photonic lens array of FIG. 9;
FIGS. 13A, 13B, 13C, and 13D are diagrams showing various arrangements of a plurality of unit patterns in a first supercell of a nano-photonic lens array;
FIGS. 14A, 14B, 14C, 14D, 14E, and 14F are diagrams showing examples of various arrangements of a plurality of unit patterns in a second supercell of a nano-photonic lens array;
FIGS. 15A, 15B, 15C, and 15D are diagrams showing examples of various arrangements of a plurality of unit patterns in a third supercell of a nano-photonic lens array;
FIGS. 16A, 16B, 16C, 16D, 16E, 16F, 16G, and 16H are diagrams showing examples of various arrangements of a plurality of unit patterns in a supercell of a nano-photonic lens array according to another embodiment;
FIG. 17 is a diagram showing an example of a distribution of cross-sectional sizes of nano-structures in an entire region of a nano-photonic lens array;
FIG. 18 is an enlarged view showing part A1 of a nano-photonic lens array in FIG. 17;
FIG. 19 is a diagram showing an example of an image generated by an image sensor according to a related example;
FIG. 20 is a diagram showing an example of an image generated by an image sensor according to an example embodiment;
FIGS. 21 and 22 are diagrams showing examples of various arrangements of a plurality of unit patterns in a supercell of a nano-photonic lens array, when cross-sectional sizes of nano-structures are independently changed in a plurality of lenses;
FIG. 23 is a block diagram of an electronic device including an image sensor according to an embodiment;
FIG. 24 is a block diagram schematically showing a camera module of FIG. 23;
FIG. 25 is a block diagram of an electronic device including a multi-camera module; and
FIG. 26 is a detailed block diagram of a multi-camera module in the electronic device of FIG. 25.

### DETAILED DESCRIPTION

Reference will now be made in detail to embodiments, examples of which are illustrated in the accompanying drawings, wherein like reference numerals refer to like elements throughout. In this regard, the example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, an image sensor including a nano-photonic lens array and an electronic apparatus including the image sensor will be described in detail with reference to accompanying drawings. The embodiments of the disclosure are capable of various modifications and may be embodied in many different forms. In the drawings, like reference numerals denote like components, and sizes of components in the drawings may be exaggerated for convenience of explanation.

When a layer, a film, a region, or a panel is referred to as being "on" another element, it may be directly on/under/at left/right sides of the other layer or substrate, or intervening layers may also be present.

It will be understood that although the terms "first," "second," etc. may be used herein to describe various components, these components should not be limited by these terms. These components are only used to distinguish one component from another. These terms do not limit that materials or structures of components are different from one another.

An expression used in the singular encompasses the expression of the plural, unless it has a clearly different meaning in the context. It will be further understood that when a portion is referred to as "comprising" another component, the portion may not exclude another component but may further comprise another component unless the context states otherwise.

In addition, the terms such as "... unit", "module", etc. provided herein indicates a unit performing a function or operation, and may be realized by hardware, software, or a combination of hardware and software.

The use of the terms of "the above-described" and similar indicative terms may correspond to both the singular forms and the plural forms.

Also, the steps of all methods described herein may be performed in any suitable order unless otherwise indicated herein or otherwise clearly contradicted by context. Also, the use of all exemplary terms (for example, etc.) is only to describe technical detail, and the scope of rights is not limited by these terms unless the context is limited by the claims.

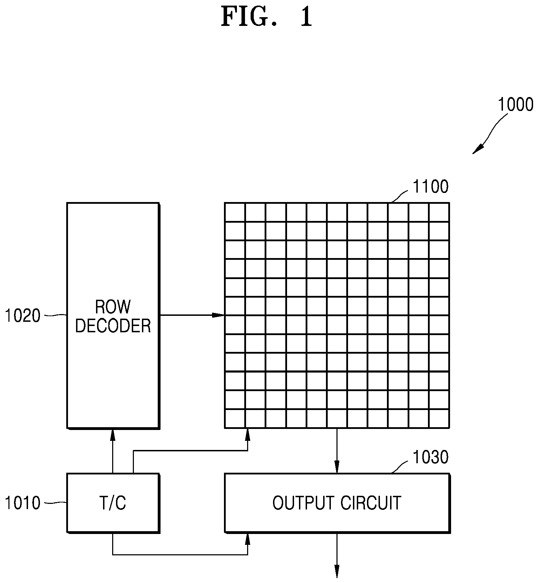

FIG. 1 is a schematic block diagram of an image sensor according to an example embodiment. Referring to FIG. 1, an image sensor 1000 may include a pixel array 1100, a timing controller 1010, a row decoder 1020, and an output circuit 1030. The image sensor 1000 may be a charge-coupled device (CCD) image sensor or a complementary metal oxide semiconductor (CMOS) image sensor.

The pixel array 1100 includes pixels that are two-dimensionally disposed in a plurality of rows and columns. The row decoder 1020 selects one of the rows in the pixel array 1100 in response to a row address signal output from the timing controller 1010. The output circuit 1030 outputs a photosensitive signal, in a line unit, from a plurality of pixels disposed in the selected row. To this end, the output circuit 1030 may include a column decoder and an analog-to-digital converter (ADC). For example, the output circuit 1030 may include a plurality of ADCs that are disposed respectively to columns between the column decoder and the pixel array 1100, or one ADC disposed at an output end of the column decoder. The timing controller 1010, the row decoder 1020, and the output circuit 1030 may be implemented as one chip or in separate chips. A processor for processing an image signal output from the output circuit 1030 may be implemented as one chip with the timing controller 1010, the row decoder 1020, and the output circuit 1030.

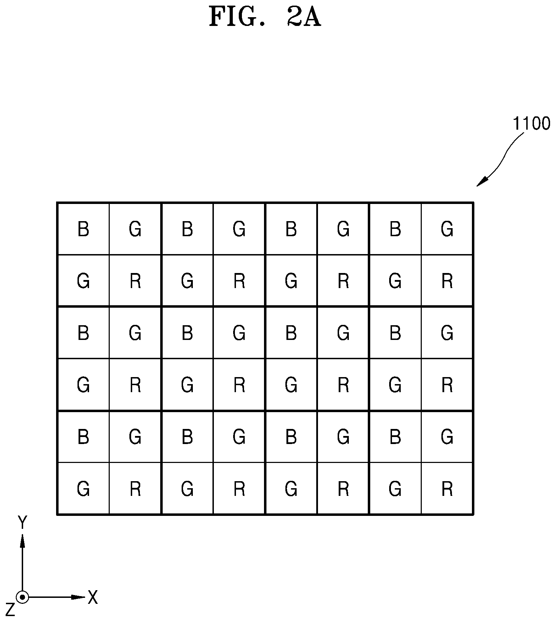

The pixel array 1100 may include a plurality of pixels that sense light of different wavelengths. The pixel arrangement may be implemented in various ways. For example, FIGS. 2A to 2C show various pixel arrangements in the pixel array 1100 of the image sensor 1000.

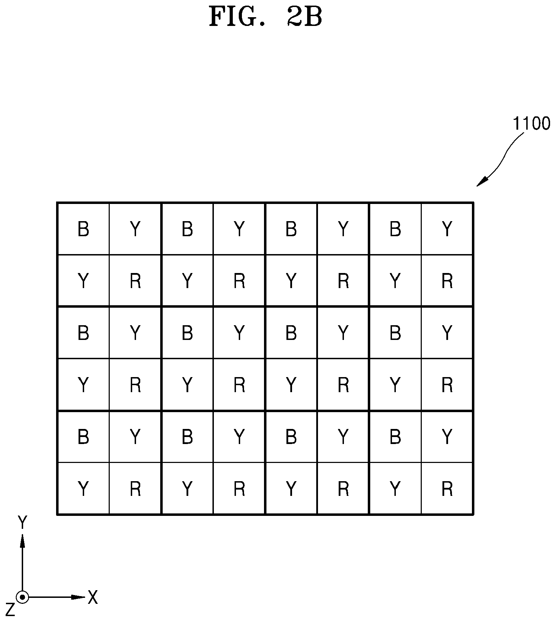

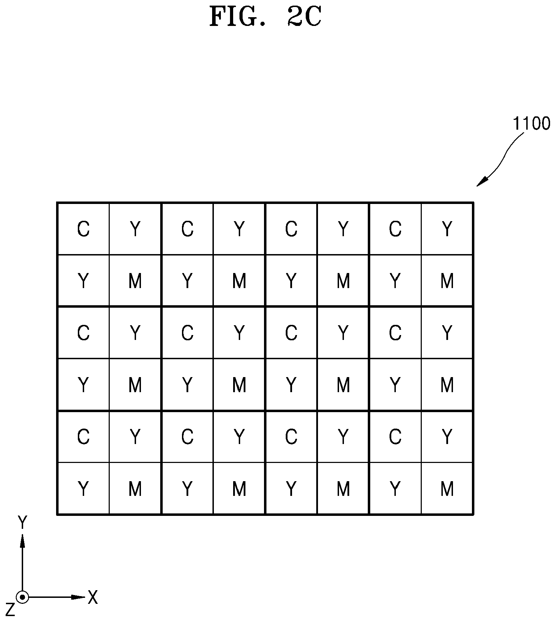

FIG. 2 shows a Bayer pattern that is generally used in the image sensor 1000. Referring to FIG. 2A, one unit pattern includes four quadrant regions, and first through fourth quadrants may be the green pixel G, the blue pixel B, the green pixel G, and the red pixel R, respectively. The unit patterns may be repeatedly two-dimensionally disposed in a first direction (an X direction) and a second direction (a Y direction). For example, two green pixels G are disposed in one diagonal direction and one blue pixel B and one red pixel R are disposed in another diagonal direction in a unit pattern of a 2×2 array. In the entire arrangement of pixels, a first row in which a plurality of blue pixels B and a plurality of green pixels G are alternately disposed in the first direction and a second row in which a plurality of green pixels G and a plurality of red pixels R are alternately disposed in the first direction are repeatedly disposed in a second direction.

The pixel array 1100 may be disposed in various arrangement patterns, rather than the Bayer pattern. For example, referring to FIG. 2B, a red-yellow-blue (RYB) arrangement in which a yellow pixel Y is used instead of a green pixel G in the Bayer pattern may be used. Also, referring to FIG. 2C, a cyan-magenta-yellow (CMY) arrangement in which a cyan pixel C, a magenta pixel M, and two yellow pixels Y form one unit pattern may be used. An RGBW arrangement, in which a green pixel G, a red pixel R, a blue pixel B, and a white pixel W form one unit pattern, may be used. In addition to the above examples, the pixels in the pixel array 1100 may be disposed in various ways according to color characteristics of the image sensor 1000. Hereinafter, it will be described that the pixel array 1100 of the image sensor 1000 has a Bayer pattern, but the operating principles may be applied to other patterns of pixel arrangement than the Bayer pattern.

Hereinafter, for convenience of description, an example in which the pixel array 1100 has a Bayer pattern structure will be described as an example.

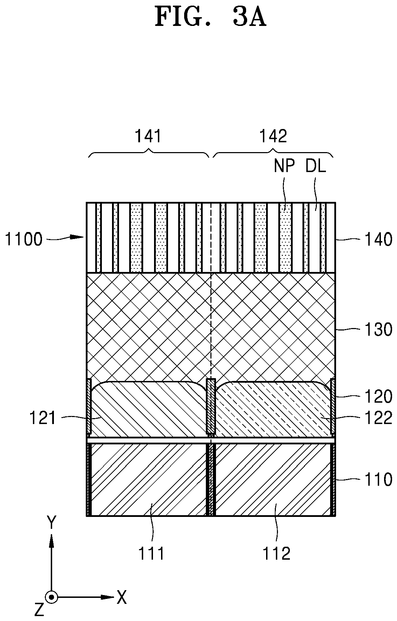

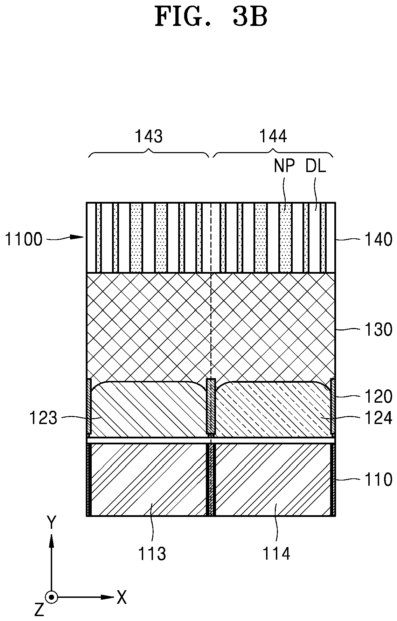

FIGS. 3A and 3B are cross-sectional views schematically showing a structure of the pixel array 1100 in the image sensor 1000 according to an example embodiment. FIG. 3A shows a cross-section of the pixel array 1100 taken along the first direction (X-direction), and FIG. 3B shows a cross-section of the pixel array 1100, taken along the first direction (X-direction) at a location different from that of FIG. 3A in the second direction (Y-direction).

Referring to FIGS. 3A and 3B, the pixel array 1100 may include a sensor substrate 110, a color filter layer 120 disposed on the sensor substrate 110, a planarization layer 130 that is transparent and disposed on the color filter layer 120, and a nano-photonic lens array 140 disposed on the planarization layer 130.

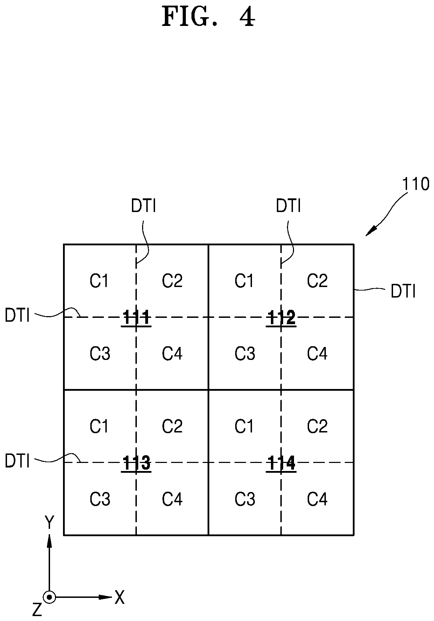

FIG. 4 is a plan view schematically showing a structure of a sensor substrate 110 in the pixel array 1100 of FIGS. 3A and 3B. Referring to FIG. 4, the sensor substrate 110 may include a plurality of pixels sensing incident light. For example, the sensor substrate 110 may include a first pixel 111, a second pixel 112, a third pixel 113, and a fourth pixel 114 that convert incident light into electrical signals and generate an image signal. The first pixel 111, the second pixel 112, the third pixel 113, and the fourth pixel 114 may form one unit pixel pattern. For example, the first pixel 111 may be a blue pixel sensing blue light, the second pixel 112 and the third pixel 113 may be green pixels sensing green light, and the fourth pixel 114 may be a red pixel sensing red light. In the sensor substrate 110, a plurality of unit pixel patterns including the first pixel 111, the second pixel 112, the third pixel 113, and the fourth pixel 114 may be periodically repeated and two-dimensionally arranged in the first direction (X-direction) and the second direction (Y-direction).

FIGS. 3A, 3B, and 4 only show one unit Bayer pattern including four pixels as an example, but the pixel array 1100 may include a plurality of Bayer patterns that are two-dimensionally arranged. For example, a plurality of first pixels 111 and a plurality of second pixels 112 may be alternately disposed in a first direction, and a plurality of third pixels 113 and a plurality of fourth pixels 114 may be alternately disposed in the first direction on a cross-section located differently in a second direction perpendicular to the first direction. Also, the plurality of first pixels 111 and the plurality of fourth pixels 114 may be disposed in a first diagonal direction and the plurality of second pixels 112 and the plurality of third pixels 113 may be disposed in a second diagonal direction crossing the first diagonal direction.

In an example, each of the first to fourth pixels 111, 112, 113, and 114 may include one photosensitive cell. For example, each of the first to fourth pixels 111, 112, 113, and 114 may include one photodiode.

In another example, each of the first to fourth pixels 111, 112, 113, and 114 may include a plurality of photosensitive cells that independently sense incident light. In this case, each of the first to fourth pixels 111, 112, 113, and 114 may include a plurality of photodiodes. For example, each of the first to fourth pixels 111, 112, 113, and 114 may include a first photosensitive cell C1, a second photosensitive cell C2, a third photosensitive cell C3, and a fourth photosensitive cell C4. The first to fourth photosensitive cells C1, C2, C3, and C4 may be two-dimensionally disposed in the first direction and the second direction. For example, in each of the first to fourth pixels 111, 112, 113, and 114, the first to fourth photosensitive cells C1, C2, C3, and C4 may be disposed in a 2x2 array.

FIG. 4 shows an example in which each of the first to fourth pixels 111, 112, 113, and 114 includes four photosensitive cells, but four or more independent photosensitive cells that are separate from each other may be grouped and two-dimensionally disposed. For example, each of the first to fourth pixels 111, 112, 113, and 114 may include a plurality of independent photosensitive cells that are grouped and disposed in a 3x3 array or 4x4 array. Hereinafter, an example in which each of the first to fourth pixels 111, 112, 113, and 114 includes the photosensitive cells disposed in a 2x2 array will be described for convenience of description.

When each of the first to fourth pixels 111, 112, 113, and 114 includes a plurality of photosensitive cells, an auto-focusing signal may be obtained from a difference between output signals from adjacent photosensitive cells. For example, an auto-focusing signal in the first direction may be generated from a difference between output signals from the first photosensitive cell C1 and the second photosensitive cell C2, a difference between output signals from the third photosensitive cell C3 and the fourth photosensitive cell C4, or a difference between a sum of the output signals from the first photosensitive cell C1 and the third photosensitive cell C3 and a sum of the output signals from the second photosensitive cell C2 and the fourth photosensitive cell C4. Also, an auto-focusing signal in the second direction may be generated from a difference between output signals from the first photosensitive cell C1 and the third photosensitive cell C3, a difference between output signals from the second photosensitive cell C2 and the fourth photosensitive cell C4, or a difference between a sum of the output signals from the first photosensitive cell C1 and the second photosensitive cell C2 and a sum of the output signals from the third photosensitive cell C3 and the fourth photosensitive cell C4.

A general image signal may be obtained by summing output signals from the first to fourth photosensitive cells C1, C2, C3, and C4. For example, a blue image signal may be generated by summing the output signals from the first to fourth photosensitive cells C1, C2, C3, and C4 of the first pixel 111, a first green image signal may be generated by summing the output signals from the first to fourth photosensitive cells C1, C2, C3, and C4 the second pixel 112, a second green image signal may be generated by summing the output signals from the first to fourth photosensitive cells C1, C2, C3, and C4 of the third pixel 113, and a red image signal may be generated by summing the output signals from the first to fourth photosensitive cells C1, C2, C3, and C4 of the fourth pixel 114.

Also, each of the first to fourth pixels 111, 112, 113, and 114 may include isolations DTI that electrically isolate the plurality of photosensitive cells from one another. The isolation DTI may have, for example, a deep trench isolation structure. The deep trench may be filled with, for example, air or an electrically insulating material. The isolations DTI may extend in the first direction and the second direction to divide each of the first to fourth pixels 111, 112, 113, and 114 into four. The first to fourth photosensitive cells C1, C2, C3, and C4 in each of the first to fourth pixels 111, 112, 113, and 114 may be isolated from one another by the isolations DTI. The isolation DTI extending in the first direction and the isolation DTI extending in the second direction may cross each other at the center of each of the first to fourth pixels 111, 112, 113, and 114.

Also, the isolations DTI may be disposed in the first direction and the second direction between adjacent pixels from among the first to fourth pixels 111, 112, 113, and 114. Therefore, the first to fourth pixels 111, 112, 113, and 114 may be isolated from one another due to the isolations DTI. The isolation DTI extending in the first direction and the isolation DTI extending in the second direction may cross each other at the center of the unit Bayer pattern including the first to fourth pixels 111, 112, 113, and 114.

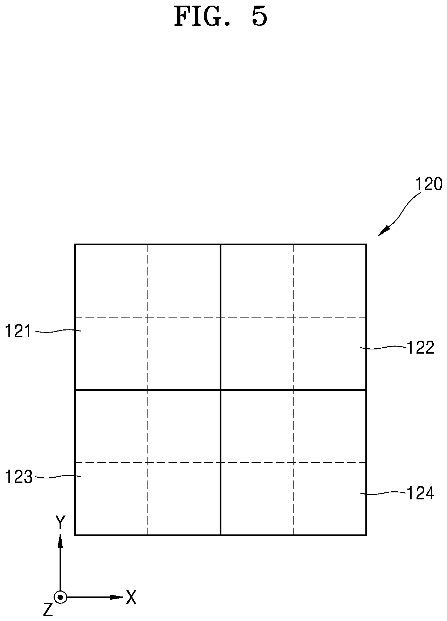

FIG. 5 is a plan view schematically showing a structure of the color filter layer 120 of FIGS. 3A and 3B. Referring to FIG. 5, the color filter layer 120 may include a plurality of color filters that are disposed between the sensor substrate 110 and the nano-photonic lens array 140 to transmit light of a certain wavelength band and absorb light of another wavelength band. For example, the color filter layer 120 may include a first color filter 121 that transmits light of a first wavelength band and absorbs light of wavelength band other than the first wavelength band, a second color filter 122 and a third color filter 123 that transmit light of a second wavelength band that is different from the first wavelength band and absorb light of wavelength band other than the second wavelength band, and a fourth color filter 124 that transmits light of a third wavelength band that is different from the first and second wavelength bands and absorbs light of wavelength band other than the third wavelength band. FIG. 5 only shows an example of one unit Bayer pattern, but a plurality of first color filters 121 and a plurality of second color filters 122 may be alternately disposed in the first direction, and a plurality of third color filters 123 and a plurality of fourth color filters 124 may be alternately disposed in the first direction on a cross-section that is at a different location in the second direction that is perpendicular to the first direction.

The first color filter 121 may be disposed to face the first pixel 111 in a third direction (Z-direction), the second color filter 122 may be disposed to face the second pixel 112 in the third direction, the third color filter 123 may be disposed to face the third pixel 113 in a third direction, and the fourth color filter 124 may be disposed to face the fourth pixel 114 in the third direction. Accordingly, the first pixel 111 may sense the light of the first wavelength band that passed through the first color filter 121 corresponding thereto. The second pixel 112 senses the light of the second wavelength band that passed through the corresponding second color filter 122, and the third pixel 113 senses the light of the second wavelength band that passed through the corresponding third color filter 123. The fourth pixel 114 may sense the light of the third wavelength band that has passed through the fourth color filter 124 corresponding thereto. For example, the first color filter 121 may be a blue color filter transmitting blue light, the second and third color filters 122 and 123 may be green color filters transmitting green light, and the fourth color filter 124 may be a red color filter transmitting red light.

Dashed lines shown in FIG. 5 indicate the isolations between the photosensitive cells in the first to fourth pixels 111, 112, 113, and 114. As shown in FIG. 5, the first to fourth color filters 121, 122, 123, and 124 may be disposed to face all the photosensitive cells in the first to fourth pixels 111, 112, 113, and 114 respectively corresponding thereto in the third direction. For example, the first color filter 121 may cover and face all photosensitive cells in the first pixel 111, the second color filter 122 may cover and face all photosensitive cells in the second pixel 112, the third color filter 123 may cover and face all photosensitive cells in the third pixel 113, and the fourth color filter 124 may cover and face all photosensitive cells in the fourth pixel 114.

The first to fourth color filters 121, 122, 123, and 124 in the color filter layer 120 may be formed of, for example, an organic polymer material. For example, the first to fourth color filters 121, 122, 123, and 124 may include a coloring agent, binder resin, polymer photoresist, etc. The first color filter 121 may be an organic color filter including a blue organic dye or a blue organic pigment as a coloring agent, the second and third color filters 122 and 123 may be organic color filters including a green organic dye or a green organic pigment as a coloring agent, and the fourth color filter 124 may be an organic color filter including a red organic dye or a red organic pigment as a coloring agent. Although not shown in FIGS. 3A, 3B, and 5 for convenience's sake, the color filter layer 120 may further include a black matrix disposed at boundaries between the first to fourth color filters 121, 122, 123, and 124. The black matrix may include, for example, carbon black.

Referring back to FIGS. 3A and 3B, the planarization layer 130 arranged between the color filter layer 120 and the nano-photonic lens array 140 may have a flat surface for forming the nano-photonic lens array 140 thereon. The planarization layer 130 may include an organic polymer material that may be stacked on the color filter layer 120 that is formed of an organic material and may more easily form a flat surface. The organic polymer material forming the planarization layer 130 may be transparent with respect to visible light. For example, the planarization layer 130 may include at least one organic polymer material from an epoxy resin, polyimide, polycarbonate, polyacrylate, and polymethyl methacrylate (PMMA). The planarization layer 130 may be formed on the color filter layer 120 by, for example, a spin coating method, and may have a flat upper surface through a thermal treatment.

The nano-photonic lens array 140 may be disposed on the planarization layer 130. FIGS. 3A and 3B show that the nano-photonic lens array 140 is directly disposed on the planarization layer 130, but a protective layer for preventing damage to the planarization layer 130 that is formed of an organic polymer material during the process of forming the nano-photonic lens array 140 may be disposed on the planarization layer 130, and then, the nano-photonic lens array 140 may be disposed on the protective layer. Also, in order to protect the planarization layer 130 while forming the nano-photonic lens array 140, an etch stop layer may be further arranged between the planarization layer 130 and the nano-photonic lens array 140.

The nano-photonic lens array 140 may be formed to color-separate incident light. For example, the nano-photonic lens array 140 may separate the light of first wavelength band (e.g., blue light), the light of second wavelength band (e.g., green light), and the light of third wavelength band (e.g., red light) from the incident light and allow the separated light to proceed in different passages. Also, the nano-photonic lens array 140 may be configured to also function as a lens for condensing the separated blue light, the green light, and the red light onto pixels. In particular, the nano-photonic lens array 140 may be configured to condense the blue light, in the incident light, onto the first pixel 111, the green light onto the second pixel 112 and the third pixel 113, and the red light onto the fourth pixel 114.

To condense light, the nano-photonic lens array 140 may include a plurality of nano-structures NP that are periodically disposed according to a certain rule. Also, the nano-photonic lens array 140 may further include a dielectric layer DL filled between the plurality of nano-structures NP. In order for the nano-photonic lens array 140 to perform the above functions, the plurality of nano-structures NP of the nano-photonic lens array 140 may be variously formed.

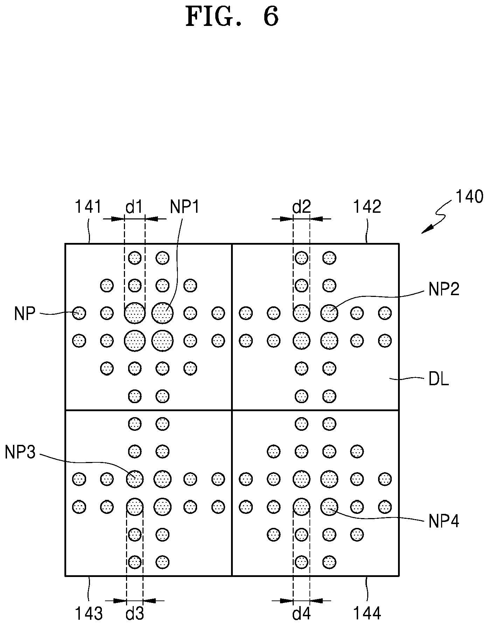

FIG. 6 is a plan view showing an example of on unit pattern in the nano-photonic lens array 140 of FIGS. 3A and 3B.

Referring to FIG. 6, the nano-photonic lens array 140 may include a first pixel corresponding region 141 corresponding to the first pixel 111, a second pixel corresponding region 142 corresponding to the second pixel 112, a third pixel corresponding region 143 corresponding to the third pixel 113, and a fourth pixel corresponding region 144 corresponding to the fourth pixel 114. The first pixel corresponding region 141 may be arranged to face the first pixel 111 in the third direction, the second pixel corresponding region 142 may be arranged to face the second pixel 112 in the third direction, the third pixel corresponding region 143 may be arranged to face the third pixel 113 in the third direction, and the fourth pixel corresponding region 144 may be arranged to face the fourth pixel 114 in the third direction. Although FIG. 6 shows only one unit pattern as an example, a plurality of first pixel corresponding regions 141 and a plurality of second pixel corresponding regions 142 may be alternately arranged in the first direction, and a plurality of third pixel corresponding region 143 and a plurality of fourth pixel corresponding regions 144 may be alternately disposed in the first direction on a cross-section that is at a different location in the second direction that is perpendicular to the first direction. For example, the nano-photonic lens array 140 may include a plurality of unit patterns that are periodically and two-dimensionally arranged in the first and second directions. The pattern period or lattice constant of the plurality of unit patterns in the nano-photonic lens array 140 may be equal to the pattern period or lattice constant of the plurality of unit pixel patterns in the sensor substrate 110.

The nano-photonic lens array 140 may include a plurality of nano-structures NP disposed in a first pixel corresponding region 141, a second pixel corresponding region 142, a third pixel corresponding region 143, and a fourth pixel corresponding region 144 to color-separate the incident light and condense the separated light. The plurality of nano-structures NP may be disposed so that a phase of light transmitting through the nano-photonic lens array 140 is changed according to a position on the nano-photonic lens array 140. A phase profile of the transmitted light, which is implemented by the nano-photonic lens array 140, may be determined according to a cross-sectional size (e.g., width or diameter), cross-sectional shape, and a height of each of the nano-structures NP, and the arrangement period (or pitch) and arrangement type of the plurality of nano-structures NP. Also, the behavior of the light passing through the nano-photonic lens array 140 may be determined according to the phase profile of the transmitted light. For example, the plurality of nano-structures NP may be disposed to form a phase profile allowing the light transmitted through the nano-photonic lens array 140 to be separated according to wavelengths and condensed.

The nano-structures NP may each have a size that is less than a wavelength of visible light. The nano-structures NP may have a size that is less than, for example, the blue wavelength. For example, the cross-sectional width (or diameter) of the nano-structures NP in a horizontal direction may be less than 400 nm, 300 nm, or 200 nm. A height of the nano-structures NP in a vertical direction may be about 500 nm to about 1500 nm, and may be greater than the cross-sectional width of the nano-structures NP.

The nano-structures NP may include a material having a relatively higher refractive index as compared with a peripheral material and having a relatively lower absorption ratio in the visible ray band. For example, the nano-structures NP may include c-Si, p-Si, a-Si and a Group III-V compound semiconductor (gallium phosphide (GaP), gallium nitride (GaN), gallium arsenide (GaAs) etc.), silicon carbide (SiC), titanium oxide (TiO₂), silicon nitride (SiN₃), zinc sulfide (ZnS), zinc selenide (ZnSe), silicon nitride (Si₃N₄), and/or a combination thereof. Periphery of the nano-structures NP may be filled with the dielectric layer DL having a relatively lower refractive index as compared with the nano-structures NP and have a relatively low absorbent ratio in the visible ray band. For example, the dielectric layer DL may be filled with siloxane-based spin on glass (SOG), silicon oxide (SiO₂), Si₃N₄, aluminum oxide (Al₂O₃), air, etc.

The refractive index of the nano-structures NP may be about 2.0 or greater with respect to light of about a 630 nm wavelength, and the refractive index of the dielectric layer DL may be about 1.0 to about 2.0 or less with respect to light of about a 630 nm wavelength. Also, a difference between the refractive indexes of the nano-structures NP and the refractive index of the dielectric layer DL may be about 0.5 or greater. The nano-structures NP having a difference in a refractive index between the refractive index of the peripheral material may change the phase of light that passes through the nano-structures NP. This is caused by phase delay that occurs due to the shape dimension of the sub-wavelength of the nanostructures NP, and a degree at which the phase is delayed may be determined by a detailed shape dimension and arrangement shape of the nanostructures NP.

In the example shown in FIG. 6, nano-structures NP having different cross-sectional sizes may be respectively arranged on the center portions of the first, second, third, and fourth pixel corresponding regions 141, 142, 143, and 144. For example, in the first pixel corresponding region 141, four nano-structures NP1 having largest diameter d1 may be arranged in a 2x2 array at the center portion of the first pixel corresponding region 141. A plurality of nano-structures NP having diameters less than those of the nano-structures NP1 may be two-dimensionally arranged around the nano-structures NP1 at the center portion of the first pixel corresponding region 141. In the case of the fourth pixel corresponding region 144, four nano-structures NP4 may be arranged in a 2x2 array at the center portion of the fourth pixel corresponding region 144. Diameters d4 in respective four nano-structures NP4 arranged at the center portion of the fourth pixel corresponding region 144 may be equal to one another and may be less than the diameter d1 of the nano-structures NP1 arranged at the center portion of the first pixel corresponding region 141. A plurality of nano-structures NP having less diameters than those of four nano-structures NP4 may be two-dimensionally arranged around the four nano-structures NP4 arranged at the center portion of the fourth pixel corresponding region 144.

In the second and third pixel corresponding regions 142 and 143, four nano-structures NP2 and NP3 may be arranged in a 2x2 array at the center portions of the second and third pixel corresponding regions 142 and 143. Diameters d2 and d3 of the four nano-structures NP2 and NP3 arranged at the respective center portions of the second and third pixel corresponding regions 142 and 143 may be equal to each other, and may be less than the diameter d4 of the nano-structures NP4 arranged at the center portion of the fourth pixel corresponding region 144. A plurality of nano-structures NP having less diameters than those of four nano-structures NP2 and NP3 may be two-dimensionally arranged around the four nano-structures NP2 and NP3 arranged at the center portions of the second and third pixel corresponding regions 142 and 143. The arrangement of the nano-structures NP in the second pixel corresponding region 142 may be rotated by 90-degree angle with respect to the arrangement of the nano-structures NP in the third pixel corresponding region 143.

FIG. 6 shows examples of the configuration of the nano-photonic lens array 140, and the nano-photonic lens array 140 may be formed in various shapes other than the examples shown in FIG. 6. In FIG. 6, the nano-structures NP are shown to have cylindrical shapes, but cross-sectional shapes of the nano-structures NP are not limited thereto. For example, according to the design of the nano-photonic lens array 140, the nano-structures NP may be formed in pillar shapes having various different cross-sectional shapes such as rectangular shapes, triangular shapes, cross shapes, or elliptical shapes. When the cross-sectional shape of the nano-structure NP is a polygonal or an oval shape, the cross-sectional size of the nano-structure NP may be defined as a maximum width in the nano-structure NP. Therefore, the cross-sectional size of the nano-structure NP denotes the diameter when the cross-sectional shape of the nano-structure NP is circular and denotes a maximum width of the nano-structure NP when the cross-sectional shape of the nano-structure NP is a polygonal or oval shape.

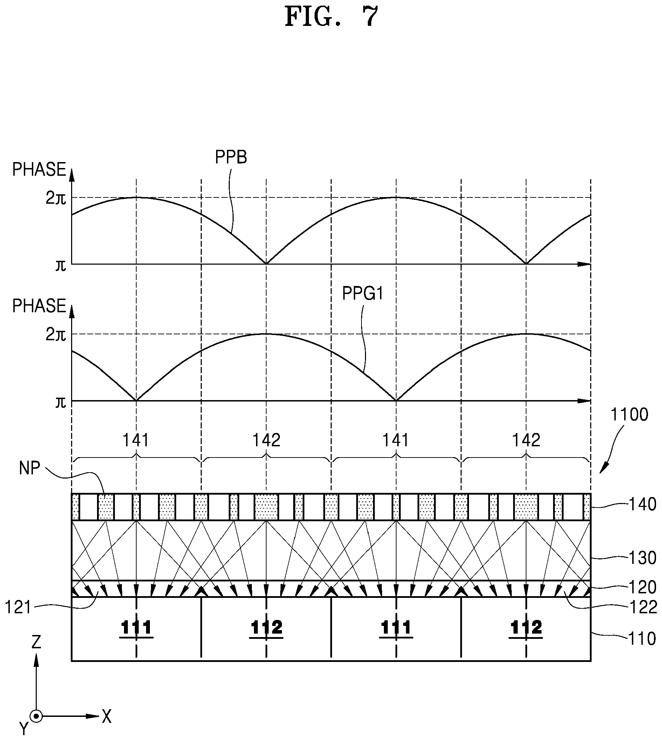

FIG. 7 is a diagram showing an example of phase profiles of blue light and green light after passing through the nano-photonic lens array of 140 FIG. 6. Referring to FIG. 7, the blue light that has passed through the nano-photonic lens array 140 may have a blue light phase profile PPB that is the largest at the center of the first pixel corresponding region 141 and is reduced away from the center of the first pixel corresponding region 141. In detail, at a position immediately after passing through the nano-photonic lens array 140, that is, on the lower surface of the nano-photonic lens array 140, the phase of the blue light is largest at the center of the first pixel corresponding region 141 and may decrease in concentric circles away from the center of the first pixel corresponding region 141.

Also, the green light that has passed through the nano-photonic lens array 140 may have a first green light phase profile PPG1 that is the largest at the center of the second pixel corresponding region 142 and is reduced away from the center of the second pixel corresponding region 142. For example, at a position immediately after passing through the nano-photonic lens array 140, that is, on the lower surface of the nano-photonic lens array 140, the phase of the green light is largest at the center of the second pixel corresponding region 142 and may decrease in concentric circles away from the center of the second pixel corresponding region 142.

Then, from the incident light incident into the first pixel corresponding region 141 and the incident light incident to portions of the second pixel corresponding region 142, the third pixel corresponding region 143, and the fourth pixel corresponding region 144 around the first pixel corresponding region 141, the blue light may be condensed onto the first pixel 111 by the nano-photonic lens array 140. Also, from the incident light incident on the second pixel corresponding region 142 and the incident light incident on portions of the first pixel corresponding region 141 and the fourth pixel corresponding region 144 around the second pixel corresponding region 142, the green light is condensed onto the second pixel 112 by the nano-photonic lens array 140.

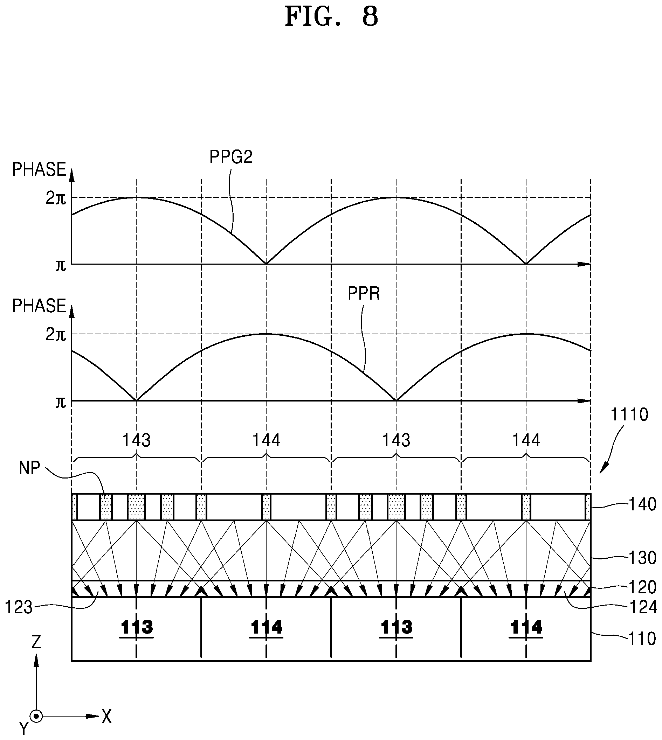

FIG. 8 is a diagram showing an example of phase profiles of red light and green light after passing through the nano-photonic lens array of 140 FIG. 6. Referring to FIG. 8, the green light that has passed through the nano-photonic lens array 140 may have a second green light phase profile PPG2 that is the largest at the center of the third pixel corresponding region 143 and is reduced away from the center of the third pixel corresponding region 143. Except that the second green light phase profile PPG2 has the largest phase at the center of the third pixel corresponding region 143, the descriptions about the first green light phase profile PPG1 may be also applied to the second green light phase profile PPG2.

Also, the red light that has passed through the nano-photonic lens array 140 may have a red light phase profile PPR that is the largest at the center of the fourth pixel corresponding region 144 and is reduced away from the center of the fourth pixel corresponding region 144. In detail, at a position immediately after passing through the nano-photonic lens array 140, the phase of the red light may be largest at the center of the fourth pixel corresponding region 144 and may decrease in concentric circles away from the center of the fourth pixel corresponding region 144.

Then, from among the incident light incident on the third pixel corresponding region 143 and the incident light incident on portions of the first pixel corresponding region 141 and the fourth pixel corresponding region 144 around the third pixel corresponding region 143, the green light is condensed onto the third pixel 113 by the nano-photonic lens array 140. Also, from among the incident light incident into the fourth pixel corresponding region 144 and the incident light incident to portions of the first pixel corresponding region 141, the second pixel corresponding region 142, and the third pixel corresponding region 143 around the fourth pixel corresponding region 144, the red light may be condensed onto the fourth pixel 114 by the nano-photonic lens array 140.

According to an example embodiment, because the nano-photonic lens array 140 described above may separate the incident light by wavelengths and condense the separated light without absorbing or blocking the incident light, the light utilization efficiency of an image sensor may be improved. Also, because the incident light is color-separated by the nano-photonic lens array 140 to a considerable degree, the absorption loss because of the color filter layer 120 may be low even when the color filter layer 120 is used. Also, color purity may be improved because the nano-photonic lens array 140 and the color filter layer 120 are used together.

A chief ray angle (CRA) of the incident light may vary depending on the position on the image sensor 1000. For example, in the center of the image sensor 1000, the incident light is incident nearly perpendicularly to the surface of the image sensor 1000, and in the edge of the image sensor 1000, the incident light may be incident to be slightly inclined. In consideration of the CRA, the nano-photonic lens array 140 may be configured so that a relatively uniform sensitivity may be obtained throughout the entire region of the image sensor 1000. According to another example embodiment, the nano-photonic lens array 140 may be configured to compensate for the deteriorated characteristics that vary depending on the position on the image sensor 1000, such as color shading, difference in the sensitivity of green light incident on the second pixel 112 and the third pixel 113, etc. For example, according to an example embodiment, the cross-sectional size of at least one nano-structure from among the nano-structures NP may be designed to vary depending on the position of the nano-structure NP on the image sensor 1000 or the nano-photonic lens array 140. For example, the unit patterns of the nano-photonic lens array 140, including the first to fourth pixel corresponding regions 141 to 144, may include the nano-structures NP having different cross-sectional sizes according to the positions on the image sensor 1000 or the nano-photonic lens array 140.

The nano-photonic lens array 140 may be manufactured by depositing a dielectric layer DL on the planarization layer 130, forming a cylindrical hole through the dielectric layer DL by etching the dielectric layer DL, and filling the material of the nano-structures NP in the hole. In this case, the cross-sectional sizes of the nano-structures NP may have discontinuous discretized values due to the reasons such as a precision of the patterning equipment including exposure equipment or manufacturing costs. For example, the cross-sectional sizes of the nano-structures NP may be implemented as integer multiples of the minimum unit. For example, when it is assumed that the minimum unit of the cross-sectional size of the nano-structure NP is 1 nm, a cross-sectional size of a smallest nano-structure NP greater than the nano-structure NP having the cross-sectional size of 150 nm may be 151 nm, and a cross-sectional size of a largest nano-structure NP less than the nano-structure NP having the cross-sectional size of 150 nm may be 149 nm. Also, when it is assumed that the minimum unit of the cross-sectional size of the nano-structure NP is 2 nm, a cross-sectional size of a smallest nano-structure NP greater than the nano-structure NP having the cross-sectional size of 150 nm may be 152 nm, and a cross-sectional size of a largest nano-structure NP less than the nano-structure NP having the cross-sectional size of 150 nm may be 148 nm. However, embodiments are not limited thereto.

In this case, the nano-structure NP having the cross-sectional size between minimum units may not be directly implemented. In the above example, when the minimum unit of the cross-sectional sizes of the nano-structures NP is 1 nm, the nano-structure NP having a cross-sectional size of, for example, 149.5 nm may not be directly implemented. Also, when the minimum unit of the cross-sectional sizes of the nano-structures NP is 2 nm, the nano-structure NP having a cross-sectional size of 151 nm may not be directly implemented. According to an example embodiment, in order to obtain the same effect as implementing nano-structures NP with cross-sectional sizes that may not be directly implemented due to resolution limitations of equipment or manufacturing costs, the plurality of unit patterns of the nano-photonic lens array 140, including the nano-structures NP having different cross-sectional sizes, may be arranged in combination.

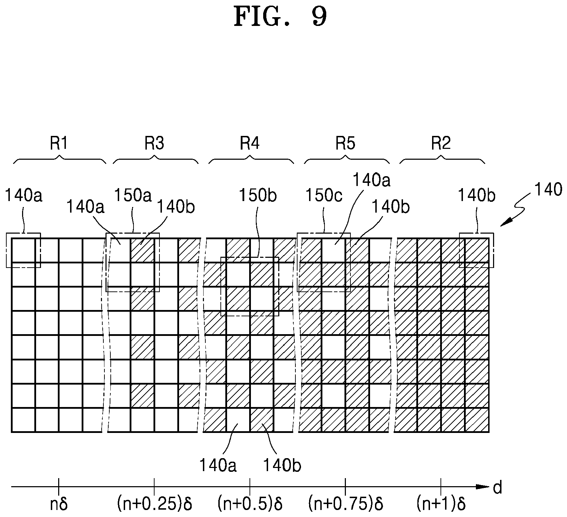

FIG. 9 is a diagram showing an example of an arrangement of unit patterns having nano-structures of different cross-sectional sizes, in a nano-photonic lens array 140. Referring to FIG. 9, the nano-photonic lens array 140 may include a first section R1, a second section R2, a third section R3 between the first section R1 and the second section R2, a fourth section R4 between the third section R3 and the second section R2, and a fifth section R5 between the fourth section R4 and the second section R2. Only a plurality of first unit patterns 140a may be arranged in the first section R1. Only a plurality of second unit patterns 140b may be arranged in the second section R2. In the first unit pattern 140a and the second unit pattern 140b, cross-sectional sizes or cross-sectional shapes of at least the nano-structures located at relatively corresponding positions from among the plurality of nano-structures arranged therein may have different cross-sectional sizes or cross-sectional shapes. For example, from among the plurality of nano-structures in the first unit pattern 140a, at least one first nano-structure may have different cross-sectional size or shape from that of a second nano-structure at the position corresponding to the first nano-structure, from among the plurality of nano-structures in the second unit pattern 140b.

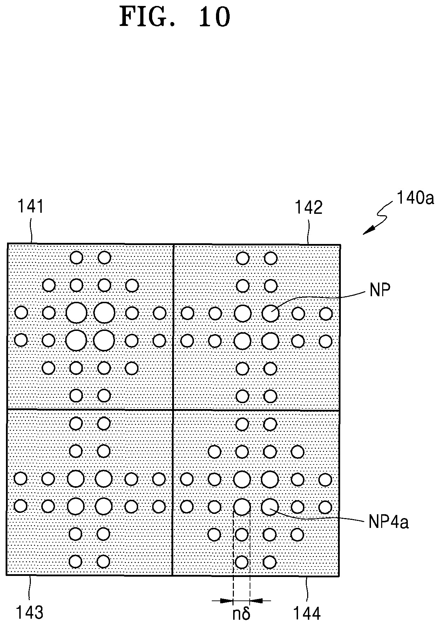

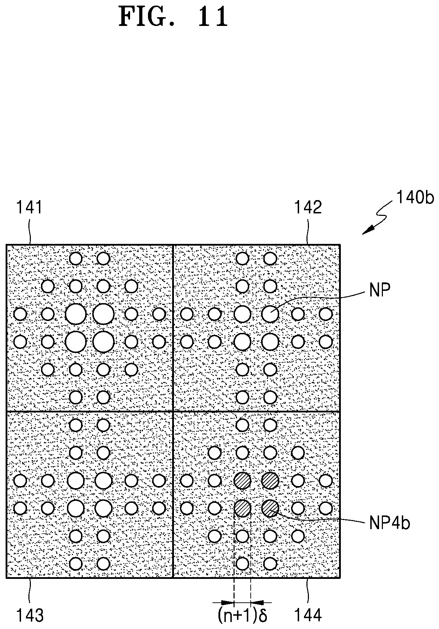

FIGS. 10 and 11 are plan views showing examples of unit patterns having nano-structures with different cross-sectional sizes. In particular, FIG. 10 shows arrangement of nano-structures NP in one first unit pattern 140a, and FIG. 11 shows arrangement of the nano-structures NP in one second unit pattern 140b. Referring to FIGS. 10 and 11, the entire arrangement types of the nano-structures NP in the first unit pattern 140a and the second unit pattern 140b may be the same as each other. Four first nano-structures NP4a arranged at the center portion of the fourth pixel corresponding region 144 in the first unit pattern 140a and four second nano-structures NP4b arranged at the center portion of the fourth pixel corresponding region 144 in the second unit pattern 140b may have different cross-sectional sizes from each other. Except for the cross-sectional sizes of the four first and second nano-structures NP4a and NP4b arranged at the center portion of the fourth pixel corresponding region 144, the nano-structures NP at the corresponding positions in the first unit pattern 140a and the second unit pattern 140b may have same cross-sectional sizes. For example, in the first and second unit patterns 140a and 140b, the cross-sectional sizes of the four first and second nano-structures NP4a and NP4b arranged at the fourth pixel corresponding regions 144 are different, but the other components may be the same as each other.

For example, the four first nano-structures NP4a arranged at the center portion of the fourth pixel corresponding region 144 of the first unit pattern 140a may each have a first cross-sectional size nδ, and four second nano-structures NP4b arranged at the center portion of the fourth pixel corresponding region 144 in the second unit pattern 140b may each have a second cross-sectional size (n+1)δ that is different from the first cross-sectional size. Here, n denotes a positive integer, and δ denotes a minimum unit of the cross-sectional sizes of the nano-structures NP. Therefore, in the first section R1 of the nano-photonic lens array 140, four first nano-structures NP4a arranged at the center portion of the fourth pixel corresponding region 144 may have the first cross-sectional sizes of nδ. Also, in the second section R2 of the nano-photonic lens array 140, four second nano-structures NP4b arranged at the center portion of the fourth pixel corresponding region 144 may have the second cross-sectional sizes of (n+1)δ.

FIGS. 10 and 11 show that the cross-sectional sizes of the four first and second nano-structures NP4a and NP4b arranged at the center portions of the fourth pixel corresponding regions 144 in the first and second unit patterns 140a and 140b are different from each other, but one or more embodiments are not limited thereto, and cross-sectional sizes or shapes of the nano-structures at different positions may be different from each other. Hereinafter, for convenience of description, a case in which the cross-sectional sizes of four first and second nano-structures NP4a and NP4b arranged at the center portion of the fourth pixel corresponding region 144 are different from each other is described.

In the third section R3, the fourth section R4, and the fifth section R5 between the first and second sections R1 and R2, the plurality of first unit patterns 140a and the plurality of second unit patterns 140b may be arranged in combination. Also, in the third, fourth, and fifth sections R3, R4, and R5, the number of the first unit patterns 140a and the number of second unit patterns 140b may be different. For example, in the third section R3 adjacent to the first section R1, the first unit patterns 140a may be more than the second unit patterns 140b, in the fifth section R5 adjacent to the second section R2, the second unit pattern 140b may be more than the first unit patterns 140a, and in the fourth section R4 between the third section R3 and the fifth section R5, the number of first unit patterns 140a may be equal to the number of second unit patterns 140b. Therefore, the number or ratio of the first unit patterns 140a may be gradually decreased and the number or ratio of the second unit patterns 140b may be gradually increased from the first section R1 sequentially to the third section R3, the fourth section R4, the fifth section R5, and the second section R2.

In order to more uniformly maintain the ratio between the first unit patterns 140a and the second unit patterns 140b throughout the entire third section R3, the third section R3 may include a plurality of first supercells 150a including the first unit patterns 140a and the second unit patterns 140b. For example, each of the plurality of first supercells 150a may include three first unit patterns 140a and one second unit pattern 140b arranged in a 2x2 array. Because the plurality of first supercells 150a are periodically and two-dimensionally arranged in the third section R3, the ratio between the first and second unit patterns 140a and 140b may be consistent at any position in the third section R3. In this case, an average cross-sectional size of four nano-structures arranged at the center portion of the fourth pixel corresponding regions 144 of the entire unit patterns in the third section R3 may be (n+0.25)δ. For example, the third region R3 may provide the same optical effect as a case in which the cross-sectional sizes of four nano-structure arranged at the center portions of the fourth pixel corresponding regions 144 are (n+0.25)δ.

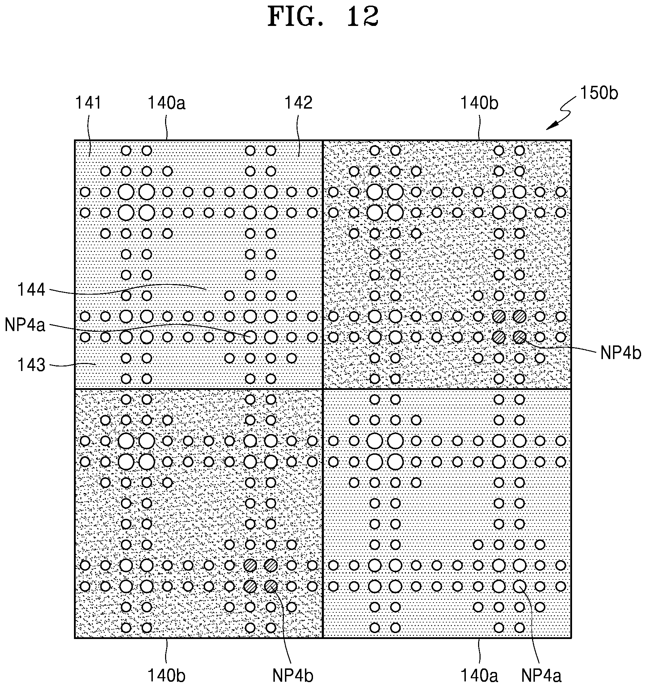

Also, the fourth section R4 may include a plurality of second supercells 150b including the first unit patterns 140a and the second unit patterns 140b of the same number. Therefore, a ratio between the first unit patterns 140a and the second unit patterns 140b within each of the plurality of second supercells 150b may be different from a ratio between the first unit patterns 140a and the second unit patterns 140b within each of plurality of first supercells 150a. FIG. 12 is a plan view showing an example of one supercell structure including a plurality of unit patterns in the nano-photonic lens array 140 of FIG. 9. In particular, FIG. 12 shows an example of one second supercell 150b arranged in the fourth section R4. Referring to FIG. 12, each of the plurality of second supercells 150b may include two first unit patterns 140a and two second unit patterns 140b arranged in a 2x2 array. For example, the first unit patterns 140a may be arranged in a second quadrant and a fourth quadrant, and the second unit patterns 140b may be arranged in a first quadrant and a third quadrant, but one or more embodiments are not limited thereto. Because the plurality of second supercells 150b are periodically and two-dimensionally arranged in the fourth section R4, the ratio between the first and second unit patterns 140a and 140b may be consistent at any position in the fourth section R4.

The second supercell 150b includes four fourth pixel corresponding regions 144, and four first nano-structures NP4a arranged at the center portion of the fourth pixel corresponding region 144 in each of two first unit patterns 140a have a first cross-sectional size of nδ, and four second nano-structures NP4b arranged at the center portion of the fourth pixel corresponding region 144 in each of the two second unit patterns 140b may have a second cross-sectional size of (n+1)δ. In this case, an average cross-sectional size of four nano-structures arranged at the center portion of the fourth pixel corresponding regions 144 of the entire unit patterns in the fourth section R4 may be (n+0.5)δ. For example, the fourth section R4 may provide the same optical effect as a case in which the cross-sectional sizes of four nano-structure arranged at the center portions of the fourth pixel corresponding regions 144 are (n+0.5)δ.

The fifth section R5 may include a plurality of third supercells 150c including the first unit patterns 140a and the second unit patterns 140b. For example, each of the plurality of third supercells 150c may include one first unit pattern 140a and three second unit patterns 140b arranged in a 2x2 array. Therefore, a ratio between the first unit patterns 140a and the second unit patterns 140b within each of the plurality of third supercells 150c may be different from the ratio between the first unit patterns 140a and the second unit patterns 140b within each of plurality of first supercells 150a and each of plurality of second supercells 150b. Because the plurality of third supercells 150c are periodically and two-dimensionally arranged in the fifth section R5, the ratio between the first and second unit patterns 140a and 140b may be consistent at any position in the fifth section R5. In this case, an average cross-sectional size of four nano-structures arranged at the center portion of the fourth pixel corresponding regions 144 of the entire unit patterns in the fifth section R5 may be (n+0.75)δ. For example, the fifth section R5 may provide the same optical effect as a case in which the cross-sectional sizes of four nano-structure arranged at the center portions of the fourth pixel corresponding regions 144 are (n+0.75)δ.

In the third section R3, the fourth section R4, and the fifth section R5, the average cross-sectional sizes of the four nano-structures arranged at the center portions of the fourth pixel corresponding regions 144, that is, (n+0.25)δ, (n+0.5)δ, and (n+0.75)b, are the cross-sectional sizes that may not be directly implemented due to the limitation in resolution of equipment or manufacturing costs. As described above, by mixing and arranging the first unit patterns 140a and the second unit patterns 140b having different cross-sectional sizes in a certain ratio, the same effect as the case in which the nano-structures NP having the cross-sectional sizes that may not be directly implemented due to the limitation in the resolution of the equipment or the manufacturing costs are implemented may be obtained. Also, by arranging the third section R3, the fourth section R4, and the fifth section R5, in which the first unit patterns 140a and the second unit patterns 140b are mixed, between the first section R1 including only the plurality of first unit patterns 140a and the second section R2 including only the plurality of second unit patterns 140b, discontinuity between the first section R1 and the second section R2 due to the discretized cross-sectional sizes nδ and (n+1)δ may be lessened. In particular, the average cross-sectional sizes of the nano-structures are gradually increased or decreased from the first section R1 to the third section R3, the fourth section R4, the fifth section R5, and the second section R2, and thus, the degradation in the image quality due to the boundary between the first section R1 and the second section R2 may be prevented or reduced.

FIG. 9 shows that the positions of the first unit patterns 140a and the second unit patterns 140b in the first supercells 150a in the third section R3 are the same as each other, positions of the first unit patterns 140a and the second unit patterns 140b in the second supercells 150b in the fourth section R4 are the same as each other, and positions of the first unit patterns 140a and the second unit patterns 140b in the third supercells 150c in the fifth section R5 are the same as each other. For example, FIG. 9 shows that the second unit patterns 140b are arranged in the first quadrant in every first supercell 150a of the third section R3, the first unit patterns 140a are arranged in the second and fourth quadrants and the second unit patterns 140b are arranged in the first and third quadrants in every second supercell 150b of the fourth section R4, and the first unit patterns 140a are arranged in the first quadrant in every third supercell 150c of the fifth section R5. However, one or more embodiments are not limited thereto, that is, a plurality of first supercells 150a, a plurality of second supercells 150b, and a plurality of third supercells 150c having different positions of the first unit patterns 140a and the second unit patterns 140b may be arranged respectively in the third section R3, the fourth section R4, and the fifth section R5.

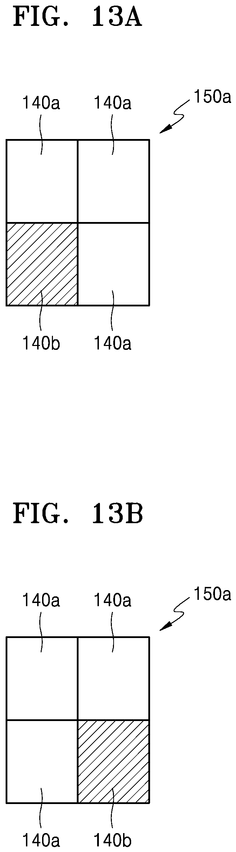

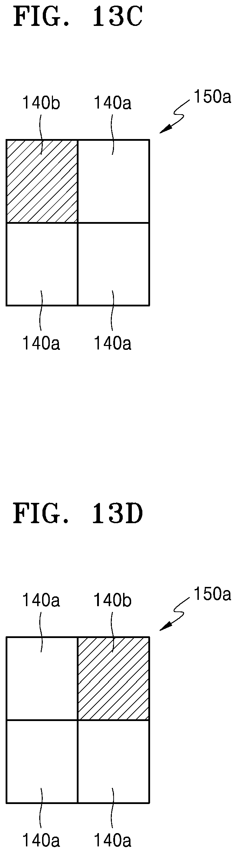

FIGS. 13A to 13D are diagrams showing various arrangements of a plurality of unit patterns in the first supercell 150a of the nano-photonic lens array 140. As shown in FIG. 13A, the first supercell 150a may include a first array in which three first unit patterns 140a are arranged in the first, second, and fourth quadrants, and the second unit patterns 140b may be arranged in the third quadrant. Alternatively, as shown in FIG. 13B, the first supercell 150a may include a second array in which three first unit patterns 140a are arranged in the first, second, and third quadrants, and the second unit patterns 140b may be arranged in the fourth quadrant. However, one or more embodiments are not limited thereto, and as shown in FIG. 13C, the first supercell 150a may include a third array in which three first unit patterns 140a are arranged in the first, third, and fourth quadrants, and the second unit patterns 140b may be arranged in the second quadrant. As shown in FIG. 13D, the first supercell 150a may include a fourth array in which three first unit patterns 140a are arranged in the second, third, and fourth quadrants, and the second unit patterns 140b may be arranged in the first quadrant. In the third section R3 shown in FIG. 9, the plurality of first supercells 150a shown in one of FIGS. 13A to 13D may be arranged. According to another example embodiment, in the third section R3, the plurality of first supercells 150a shown in FIG. 13A to 13D may be irregularly mixed and arranged. For example, various first supercells 150a including the first array, the second array, the third array, and the fourth array in which the arrangements of the first unit patterns 140a and the second unit patterns 140b are different may be irregularly arranged in the third section R3. Then, a pattern artifact due to a periodicity of the third section R3 may be averaged and reduced.

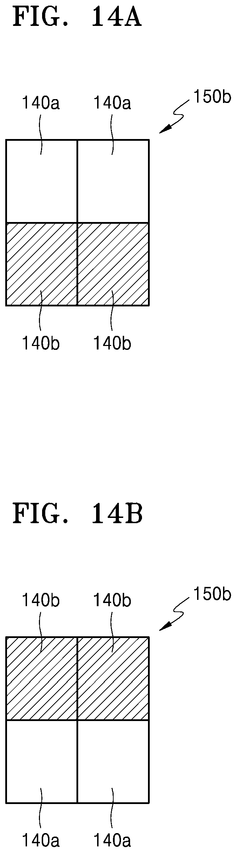

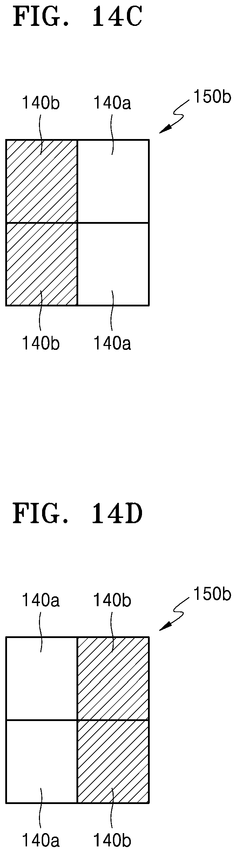

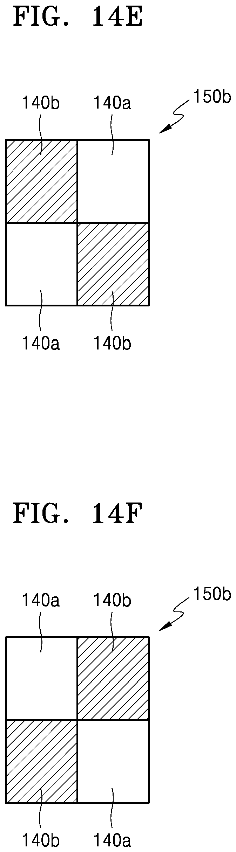

FIGS. 14A to 14F are diagrams showing examples of various arrangements of a plurality of unit patterns in the second supercell 150b of the nano-photonic lens array 140. As shown in FIG. 14A, the second supercell 150b may include a first array in which two first unit patterns 140a are arranged in the first and second quadrants, and two second unit patterns 140b may be arranged in the third and fourth quadrants. Alternatively, as shown in FIGS. 14B to 14F, the second supercell 150b may include a second array in which two first unit patterns 140a are arranged in the third and fourth quadrants and two second unit patterns 140b may be arranged in the first and second quadrants, a third array in which two first unit patterns 140a are arranged in the first and fourth quadrants and two second unit patterns 140b may be arranged in the second and third quadrants, a fourth array in which two first unit patterns 140a are arranged in the second and third quadrants and two second unit patterns 140b may be arranged in the first and fourth quadrants, a fifth array in which two first unit patterns 140a are arranged in the first and third quadrants and two second unit patterns 140b may be arranged in the second and fourth quadrants, or a sixth array in which two first unit patterns 140a are arranged in the second and fourth quadrants and two second unit patterns 140b may be arranged in the first and third quadrants. In the fourth section R4 shown in FIG. 9, the plurality of second supercells 150b shown in one of FIGS. 14A to 14F may be arranged. According to another example embodiment, in the fourth section R4, the plurality of second supercells 150b shown in FIG. 14A to 14F may be irregularly mixed and arranged. For example, various second supercells 150b including the first array, the second array, the third array, the fourth array, the fifth array, and the sixth arrary in which the arrangements of the first unit patterns 140a and the second unit patterns 140b are different may be irregularly arranged in the fourth section R4. Then, a pattern artifact due to a periodicity of the fourth section R4 may be averaged and reduced.

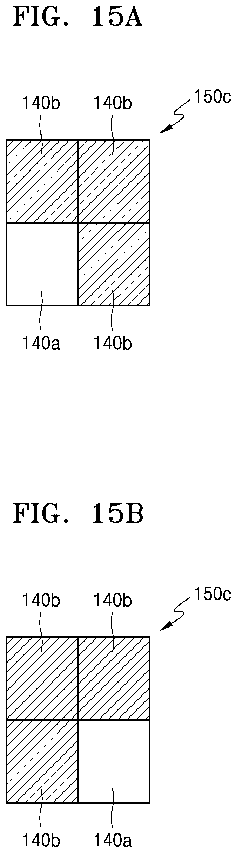

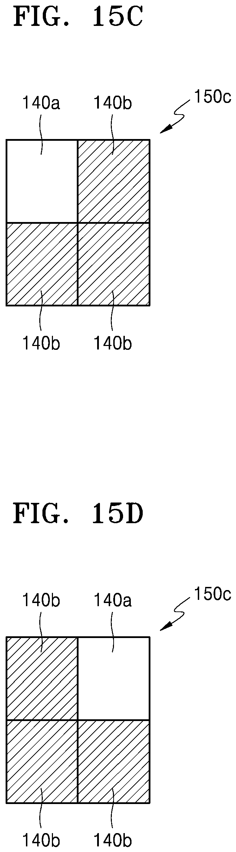

FIGS. 15A to 15D are diagrams showing examples of various arrangements of a plurality of unit patterns in the third supercell 150c of the nano-photonic lens array 140. As shown in FIGS. 15A to 15D, the third supercell 150c may include a first array in which one first unit pattern 140a is arranged in the third quadrant and three second unit patterns 140b are arranged in the first, second, and fourth quadrants, a second array in which one first unit pattern 140a is arranged in the fourth quadrant and three second unit patterns 140b are arranged in the first, second, and third quadrants, a third array in which one first unit pattern 140a is arranged in the second quadrant and three second unit patterns 140b are arranged in the first, third, and fourth quadrants, or a fourth array in which one first unit pattern 140a is arranged in the first quadrant and three second unit patterns 140b are arranged in the second, third, and fourth quadrants. In the fifth section R5 shown in FIG. 9, the plurality of third supercells 150c shown in one of FIGS. 15A to 15D may be arranged. According to another example embodiment, in the fifth section R5, the plurality of third supercells 150c shown in FIG. 15A to 15D may be irregularly mixed and arranged. For example, various third supercells 150c including the first array, the second array, the third array, and the fourth array in which the arrangements of the first unit patterns 140a and the second unit patterns 140b are different may be irregularly arranged in the fifth section R5. Then, a pattern artifact due to a periodicity of the fifth section R5 may be averaged and reduced.

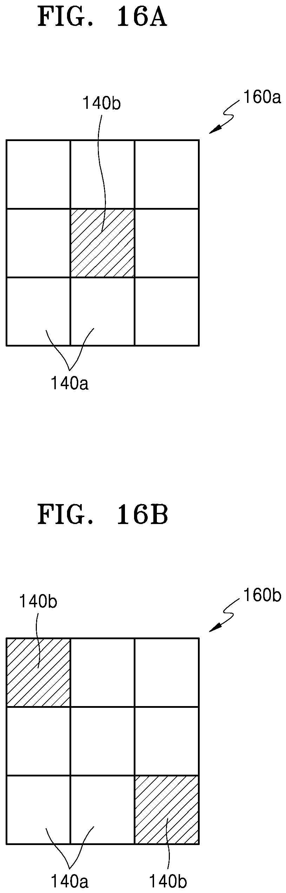

FIGS. 16A to 16H are diagrams showing examples of various arrangements of a plurality of unit patterns in a supercell of a nano-photonic lens array 140 according to another example embodiment. An example in which the supercell includes four unit patterns arranged in a 2x2 array is described, but one or more embodiments are not limited thereto. For example, one supercell may include a plurality of unit patterns arranged in an NxM array. Here, at least one of N and M may be two or greater positive integer. According to another example embodiment, one supercell may include a plurality of unit patterns arranged in a 1x2 array or a 4x1 array. In this case, one of N and M may be 1. FIGS. 16A to 16H show an example in which N and M are 3. As the values of N and M increase, the average cross-sectional size of the nano-structures may be minutely adjusted, and the discontinuity due to the discretized cross-sectional sizes n5 and (n+1)δ may be further lessened.

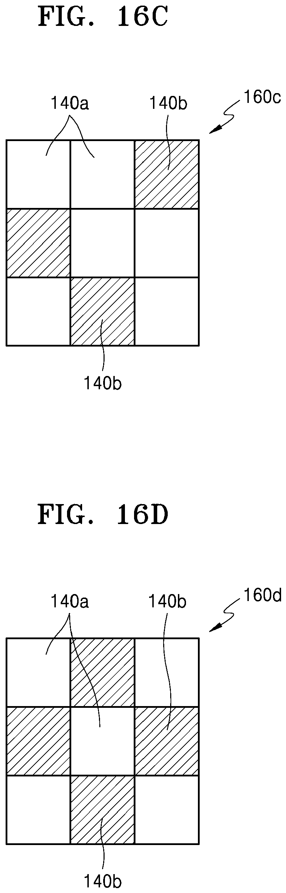

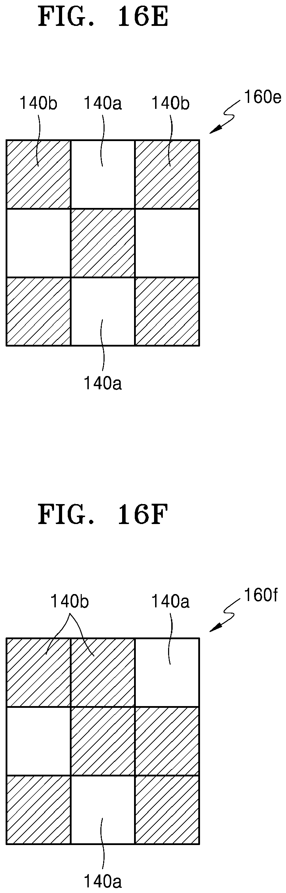

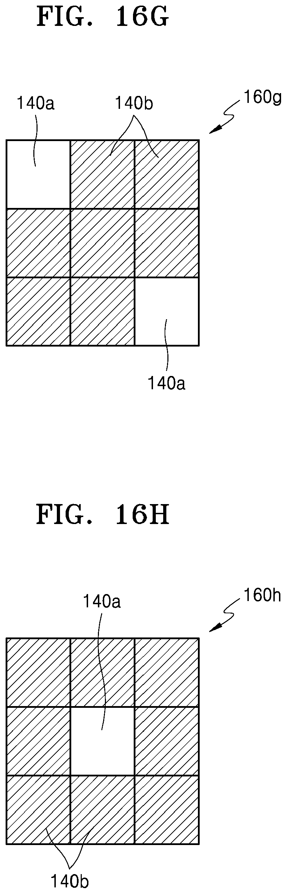

The supercell 160a shown in FIG. 16A includes eight first unit patterns 140a and one second unit pattern 140b, and in the supercell 160a, the average cross-sectional size of four nano-structures arranged at the center portion of the fourth pixel corresponding region 144 may be (n + 1/9)δ. The supercell 160b shown in FIG. 16B includes seven first unit patterns 140a and two second unit patterns 140b, and in the supercell 160b, the average cross-sectional size of four nano-structures arranged at the center portion of the fourth pixel corresponding region 144 may be (n + 2/9)δ. The supercell 160c shown in FIG. 16C includes six first unit patterns 140a and three second unit patterns 140b, and in the supercell 160c, the average cross-sectional size of four nano-structures arranged at the center portion of the fourth pixel corresponding region 144 may be (n + 1/3)δ. The supercell 160d shown in FIG. 16D includes five first unit patterns 140a and four second unit patterns 140b, and in the supercell 160d, the average cross-sectional size of four nano-structures arranged at the center portion of the fourth pixel corresponding region 144 may be (n + 4/9)δ. The supercell 160e shown in FIG. 16E includes four first unit patterns 140a and five second unit patterns 140b, and in the supercell 160e, the average cross-sectional size of four nano-structures arranged at the center portion of the fourth pixel corresponding region 144 may be (n + 5/9)δ. The supercell 160f shown in FIG. 16F includes three first unit patterns 140a and six second unit patterns 140b, and in the supercell 160f, the average cross-sectional size of four nano-structures arranged at the center portion of the fourth pixel corresponding region 144 may be (n + 2/3)δ. The supercell 160g shown in FIG. 16G includes two first unit patterns 140a and seven second unit patterns 140b, and in the supercell 160g, the average cross-sectional size of four nano-structures arranged at the center portion of the fourth pixel corresponding region 144 may be (n + 7/9)δ. The supercell 160h shown in FIG. 16H includes one first unit pattern 140a and eight second unit patterns 140b, and in the supercell 160h, the average cross-sectional size of four nano-structures arranged at the center portion of the fourth pixel corresponding region 144 may be (n + 8/9)δ.

FIG. 9 shows that all supercells in the third section R3, the fourth section R4, and the fifth section R5 includes a plurality of unit patterns arranged in a 2x2 array, but one or more embodiments are not limited thereto. For example, the supercells in one of the third, fourth, and fifth sections R3, R4, and R5 may include the plurality of unit patterns arranged in a 2x2 array as shown in FIGS. 13A to 13D, FIGS. 14A to 14F, or FIGS. 15A to 15D, and the supercells in the other sections may include the plurality of unit patterns arranged in a 3x3 array as shown in FIGS. 16A to 16H. For example, the supercells in one of the third, fourth, and fifth sections R3, R4, and R5 may include the plurality of unit patterns arranged in an N1xM1 array, and the supercells in the other sections may include the plurality of unit patterns arranged in an N2xM2 array, wherein N1 and N2 may be different positive integers or M1 and M2 may be different positive integers.

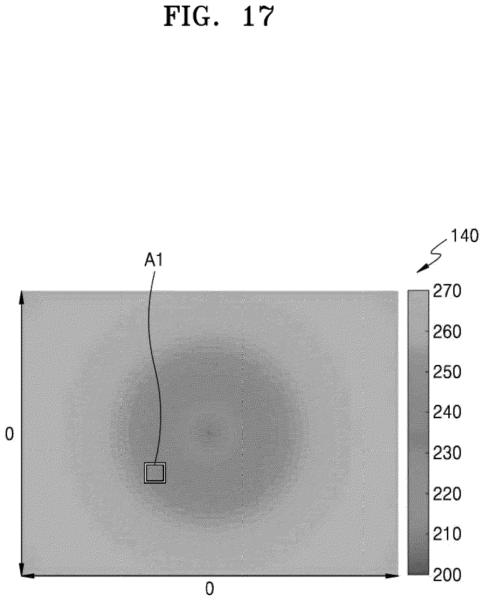

FIG. 17 is a diagram showing an example of a distribution of cross-sectional sizes of nano-structures in an entire region of a nano-photonic lens array 140. FIG. 9 shows only partial sections in the nano-photonic lens array 140 as an example, and more sections may be included in the nano-photonic lens array 140. Also, when considering the CRA of the incident light, the sections may be arranged in the form of concentric circles. For example, referring to FIG. 17, as away from the center of the nano-photonic lens array 140, the average cross-sectional size of four nano-structures arranged at the center portion of the fourth pixel corresponding region 144 may increase. In FIG. 17, a coordinate represented as 0 denotes the center of the nano-photonic lens array 140. The average cross-sectional sizes of four nano-structures arranged at the center portions of the fourth pixel corresponding regions 144 that are at the same distances from the center of the nano-photonic lens array 140 may be equal to one another.

For example, the cross-sectional sizes of four nano-structures arranged at the center portions of the fourth pixel corresponding regions 144 may be increased by the unit of 1 nm or 2 nm from 200 nm to 270 nm. Here, the increase unit may be a minimum unit or minimum processing unit determined for the reasons such as a limitation in resolution of equipment or manufacturing costs, etc. as described above. In the example, the nano-photonic lens array 140 may include a plurality of kinds of unit patterns in which the cross-sectional sizes of four nano-structures arranged at the center portions of the fourth pixel corresponding regions 144 are different from one another. In the nano-photonic lens array 140, the plurality of kinds of unit patterns may be distributed in the form of concentric circles. In some sections of the nano-photonic lens array 140, a combination of different kinds of unit patterns may be distributed. Therefore, the increase amount of the cross-sectional size of the nano-structure is, for example, 1 nm or 2 nm, but the average cross-sectional size of the four nano-structures arranged at the center portions of the fourth pixel corresponding regions 144 in the concentric circle section of the nano-photonic lens array 140 may be increased or decreased by the unit less than 1 nm or 2 nm on the basis of the distance from the center of the nano-photonic lens array 140.

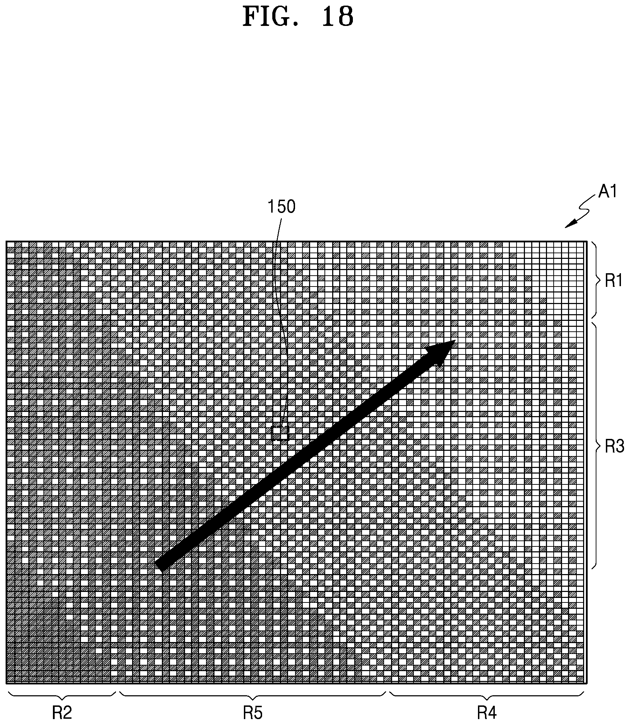

FIG. 18 is an enlarged view showing part A1 of the nano-photonic lens array 140 in FIG. 17. Referring to FIG. 18, the nano-photonic lens array 140 may include the first section R1, the second section R2, the third section R3 between the first section R1 and the second section R2, the fourth section R4 between the third section R3 and the second section R2, and the fifth section R5 between the fourth section R4 and the second section R2, which are arranged in the form of concentric circles. The first, second, third, fourth, and fifth sections R1, R2, R3, R4, and R5 shown in FIG. 18 may be the same as the first, second, third, fourth, and fifth sections R1, R2, R3, R4, and R5 shown in FIG. 9. For example, the first section R1 may only include the plurality of first unit patterns 140a. The second section R2 may only include the plurality of second unit patterns 140b, and the third, fourth, and fifth sections R3, R4, and R5 may include a plurality of supercells 150. For example, as shown in FIG. 9, the third section R3 may include a plurality of first supercells 150a each having three first unit patterns 140a and one second unit pattern 140b arranged in 2x2 array, the fourth section R4 may include a plurality of second supercells 150b each having two first unit patterns 140a and two second unit patterns 140b arranged in a 2x2 array, and the fifth section R5 may include a plurality of third supercells 150c each having one first unit pattern 140a and three second unit patterns 140b arranged in a 2x2 array. In FIG. 18, the arrow denotes a center direction of the nano-photonic lens array 140.

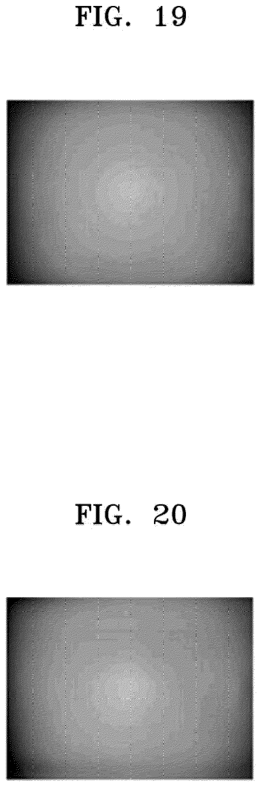

FIG. 19 is a diagram showing an example of an image generated by an image sensor according to a related example. The image sensor according to the related example includes a nano-photonic lens array that does not include a section where the first unit patterns 140a and the second unit patterns 140b are not arranged in combination. For example, when the cross-sectional sizes of four nano-structures arranged at the center portions of the fourth pixel corresponding regions 144 may be increased by the unit of 1 nm or 2 nm from 200 nm to 270 nm, according to the related example, the nano-photonic lens array may include a plurality of concentric circle sections in which different kinds of unit patterns are respectively arranged. Referring to FIG. 19, a pattern artifact such as a shading pattern in which the brightness of an image changes along boundaries between sections having different cross-sectional sizes of the nano-structures may occur. This is because the discontinuity in the cross-sectional sizes of the nano-structures among the sections.

FIG. 20 is a diagram showing an example of an image generated by an image sensor according to an example embodiment. The image sensor according to the example embodiment includes the nano-photonic lens array 140 shown in FIG. 17. For example, when the cross-sectional sizes of four nano-structures arranged at the center portions of the fourth pixel corresponding regions 144 may be increased by the unit of 1 nm or 2 nm from 200 nm to 270 nm, the nano-photonic lens array 140 may include a plurality of concentric circle sections in which different kinds of unit patterns are respectively arranged, and three intermediate sections that are arranged between two adjacent concentric circle sections and have different two kinds of unit patterns are mixed in different ratios. In this case, the nano-photonic lens array 140 may include a lot of concentric circle sections having different average cross-sectional sizes of four nano-structures arranged at the center portions of the fourth pixel corresponding regions 144. The number of concentric circle sections in the nano-photonic lens array 140 according to the example embodiment may be much greater than that of the related example. Referring to FIG. 20, two different kinds of unit patterns, in which the cross-sectional sizes of four nano-structures arranged at the center portions of the fourth pixel corresponding regions 144 are different from each other, are arranged in combination, so that the discontinuity between the sections may be lessened and the brightness of the image may be uniformed.

An example in which the cross-sectional sizes of four nano-structures arranged at the center portion of the fourth pixel corresponding regions 144 vary depending on the positions on the image sensor or the nano-photonic lens array 140 has been described. Also, the example in which the cross-sectional sizes of the nano-structures vary depending on the distances from the center of the image sensor or the nano-photonic lens array 140 is described above. However, embodiments are not limited thereto. A change in the cross-sectional sizes of the nano-structures in the nano-photonic lens array 140 may be much more complex in consideration of various quality elements in the image sensor. For example, the cross-sectional size of at least one nano-structure in the first pixel corresponding region 141, the second pixel corresponding region 142, or the third pixel corresponding region 143, as well as the fourth pixel corresponding region 144, may be changed, and the cross-sectional size of at least one nano-structure may be changed depending on the azimuth direction based on the center of the image sensor or the nano-photonic lens array 140. Also, the cross-sectional shape of at least one nano-structure may be changed according to the position on the image sensor or the nano-photonic lens array 140. For example, in a plurality of lenses, the cross-sectional size or cross-sectional shape of at least one nano-structure may be independently changed according to independent rules that may be the same or different rules.

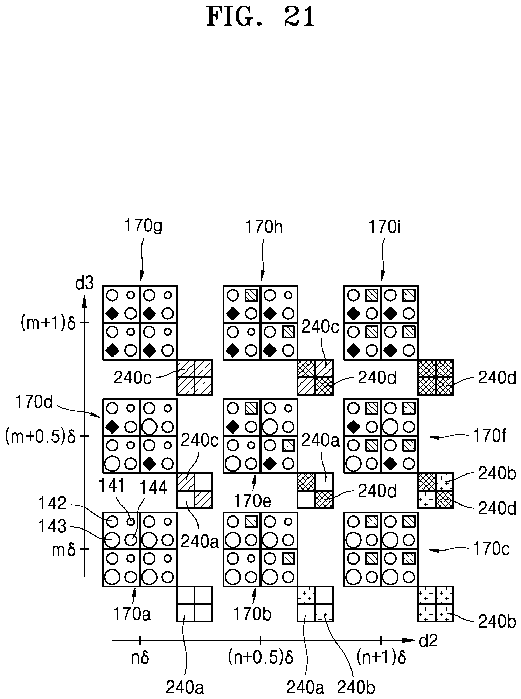

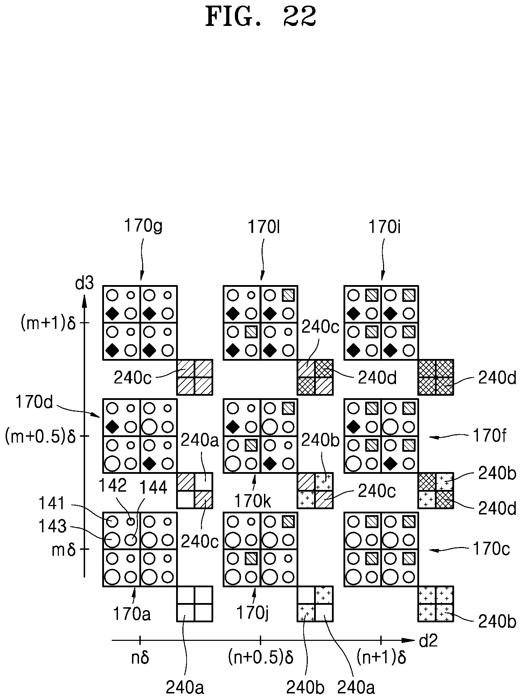

FIGS. 21 and 22 are diagrams showing examples of various arrangements of a plurality of unit patterns in a supercell of a nano-photonic lens array 140, when cross-sectional sizes of nano-structures are independently changed in a plurality of lenses. In FIGS. 21 and 22, the arrow in the transverse axis denotes the cross-sectional sizes of the nano-structures arranged at the center portion of the second pixel corresponding region 142, and the arrow in the longitudinal axis denotes the cross-sectional sizes of the nano-structures arranged at the center portion of the third pixel corresponding region 143.

Referring to FIG. 21, the nano-photonic lens array 140 may include a plurality of sections in which a plurality of supercells including a first supercell 170a, a second supercell 170b, a third supercell 170c, a fourth supercell 170d, a fifth supercell 170e, a sixth supercell 170f, a seventh supercell 170g, an eighth supercell 170h, and a ninth supercell 170i are arranged. FIG. 21 only shows one supercell for each section as a representative. Each of the first to ninth supercells 170a, 170b, 170c, 170d, 170e, 170f, 170g, 170h, and 170i may include four unit patterns arranged in 2x2 array. In each of unit patterns, circles having different sizes denote pixel corresponding regions in the unit pattern. For example, in each of unit patterns of the first supercell 170a, the smallest circle denotes the second pixel corresponding region 142, the largest circle denotes the third pixel corresponding region 143, and two circles of same size denote the first and fourth pixel corresponding regions 141 and 144. In some of the unit patterns, square and diamond figures denote pixel corresponding regions including the nano-structures having different cross-sectional sizes from those of nano-structures in the pixel corresponding regions located at the same positions in the other unit patterns. For example, the square represented in the second supercell 170b denotes the second pixel corresponding region 142. The cross-sectional size of the nano-structure in the second pixel corresponding region 142 represented as the square is different from that of the nano-structure in the second pixel corresponding region 142 represented as a circle. The diamond shape indicated in the fourth supercell 170d denotes the third pixel corresponding region 143. The cross-sectional size of the nano-structure in the third pixel corresponding region 143 represented as the diamond is different from that of the nano-structure in the third pixel corresponding region 143 represented as a circle.

The first supercell 170a may include four same first unit patterns 240a. In the first unit pattern 240a, a first nano-structure arranged at the center portion of the second pixel corresponding region 142 has a first cross-sectional size nδ, and a third nano-structure arranged at the center portion of the third pixel corresponding region 143 may have a third cross-sectional size mδ that is independent from the first cross-sectional size, for example, the third cross-sectional size may be the same as or different from the first cross-sectional size. Here, m and n are positive integers independent from each other. In the first supercell 170a, the average cross-sectional size of the nano-structure arranged at the center portion of the second pixel corresponding region 142 may be nδ and the average cross-sectional size of the nano-structure arranged at the center portion of the third pixel corresponding region 143 may be mδ.

The second supercell 170b may include two first unit patterns 240a and two second unit patterns 240b. In the second unit patterns 240b, a second nano-structure arranged at the center portion of the second pixel corresponding region 142 may have a second cross-sectional size (n+1)δ that is different from the first cross-sectional size, and a third nano-structure arranged at the center portion of the third pixel corresponding region 143 may have a third cross-sectional size mδ that is independent from the first and second cross-sectional sizes, for example, the third cross-sectional size may be the same as or different from the first and second cross-sectional sizes. Therefore, in the second supercell 170b, the average cross-sectional size of the nano-structure arranged at the center portion of the second pixel corresponding region 142 may be (n+0.5)δ and the average cross-sectional size of the nano-structure arranged at the center portion of the third pixel corresponding region 143 may be mδ.

The third supercell 170c may include four same second unit patterns 240b. Therefore, in the third supercell 170c, the average cross-sectional size of the nano-structure arranged at the center portion of the second pixel corresponding region 142 may be (n+1)δ and the average cross-sectional size of the nano-structure arranged at the center portion of the third pixel corresponding region 143 may be mδ.

The fourth supercell 170d may include two first unit patterns 240a and two third unit patterns 240c. In the third unit pattern 240c, the first nano-structure arranged at the center portion of the second pixel corresponding region 142 may have the first cross-sectional size of nδ. The fourth nano-structure arranged at the center portion of the third pixel corresponding region 143 in the third unit pattern 240c, which is at the corresponding position of the third nano-structure in the first unit pattern 240a, may have a fourth cross-sectional size (m+1)δ that is independent from the first and second cross-sectional sizes and is different from the third cross-sectional size, for example, the fourth cross-sectional size may be the same as or different from the first cross-sectional sizes. Therefore, in the fourth supercell 170d, the average cross-sectional size of the nano-structure arranged at the center portion of the second pixel corresponding region 142 may be nδ and the average cross-sectional size of the nano-structure arranged at the center portion of the third pixel corresponding region 143 may be (m+0.5)δ.

The fifth supercell 170e may include two first unit patterns 240a and two fourth unit patterns 240d. In the fourth unit pattern 240d, the second nano-structure arranged at the center portion of the second pixel corresponding region 142 has the second cross-sectional size (n+1)δ, and a fourth nano-structure arranged at the center portion of the third pixel corresponding region 143 may have a fourth cross-sectional size (m+1)δ. Therefore, in the fifth supercell 170e, the average cross-sectional size of the nano-structure arranged at the center portion of the second pixel corresponding region 142 may be (n+0.5)5 and the average cross-sectional size of the nano-structure arranged at the center portion of the third pixel corresponding region 143 may be (m+0.5)δ.

The sixth supercell 170f may include two second unit patterns 240b and two fourth unit patterns 240d. Therefore, in the sixth supercell 170f, the average cross-sectional size of the nano-structure arranged at the center portion of the second pixel corresponding region 142 may be (n+1)δ and the average cross-sectional size of the nano-structure arranged at the center portion of the third pixel corresponding region 143 may be (m+0.5)δ.

The seventh supercell 170g may include four same third unit patterns 240c. Therefore, in the seventh supercell 170g, the average cross-sectional size of the nano-structure arranged at the center portion of the second pixel corresponding region 142 may be nδ and the average cross-sectional size of the nano-structure arranged at the center portion of the third pixel corresponding region 143 may be (m+1)δ.

The eighth supercell 170h may include two third unit patterns 240c and two fourth unit patterns 240d. Therefore, in the eighth supercell 170h, the average cross-sectional size of the nano-structure arranged at the center portion of the second pixel corresponding region 142 may be (n+0.5)δ and the average cross-sectional size of the nano-structure arranged at the center portion of the third pixel corresponding region 143 may be (m+1)δ.

Lastly, the ninth supercell 170i may include four same fourth unit patterns 240d. Therefore, in the ninth supercell 170i, the average cross-sectional size of the nano-structure arranged at the center portion of the second pixel corresponding region 142 may be (n+1)δ and the average cross-sectional size of the nano-structure arranged at the center portion of the third pixel corresponding region 143 may be (m+1)δ.

The arrangement of the unit patterns shown in FIG. 22 may be similar to the arrangement of the unit patterns shown in FIG. 21, and some of the unit patterns is different from FIG. 21. For example, instead of the second supercell 170b, the fifth supercell 170e, and the eighth supercell 170h shown in FIG. 21, in FIG. 22, a tenth supercell 170j, an eleventh supercell 170k, and a twelfth supercell 170l may be respectively arranged.

The tenth supercell 170j has an arrangement in which the positions of the first unit patterns 240a and the second unit patterns 240b in the second supercell 170b are exchanged with each other. In the tenth supercell 170j, the average cross-sectional sizes of the nano-structures arranged at the center portions of the second pixel corresponding region 142 and the third pixel corresponding region 143 may be the same as the average cross-sectional sizes of the nano-structures arranged at the second and third pixel corresponding regions 142 and 143 in the second supercell 170b.

The eleventh supercell 170k may include two second unit patterns 240b and two third unit patterns 240c, instead of the two first unit patterns 240a and the two fourth unit patterns 240d. Therefore, the average cross-sectional sizes of the nano-structures arranged at the center portions of the second pixel corresponding region 142 and the third pixel corresponding region 143 in the eleventh supercell 170k may be the same as the average cross-sectional sizes of the nano-structures arranged at the second and third pixel corresponding regions 142 and 143 in the fifth supercell 170e.

Also, the twelfth supercell 170l may have an arrangement in which positions of the third and fourth unit patterns 240c and 240d in the eight supercell 170h are exchanged with each other. Therefore, the average cross-sectional sizes of the nano-structures arranged at the center portions of the second pixel corresponding region 142 and the third pixel corresponding region 143 in the twelfth supercell 170l may be the same as the average cross-sectional sizes of the nano-structures arranged at the second and third pixel corresponding regions 142 and 143 in the eighth supercell 170h.

As described above, the nano-photonic lens array 140 may include a plurality of kinds of supercells in which the unit patterns selected from the first unit patterns 240a, the second unit patterns 240b, the third unit patterns 240c, and the fourth unit patterns 240d are arranged in an NxM array. For example, the plurality of kinds of supercells may include various combinations of the first, second, third, and fourth unit patterns 240a, 240b, 240c, and 240d. Through the various supercells including at least one of the first, second, third, and fourth unit patterns 240a, 240b, 240c, and 240d, the average cross-sectional sizes or the cross-sectional shapes of at least one nano-structure may be independently and gradually changed in the nano-photonic lens array 140.

The image sensor 1000 according to the example embodiment may have the improved light utilization efficiency and reduced degradation in the resolution. Also, the image sensor 1000 according to the example embodiment may provide images of excellent image quality, in which the pattern artifact cause by the changes in the discretized cross-sectional sizes of the nano-structures rarely occurs. Therefore, a size of one pixel or size of independent photosensitive cells in the pixel of the image sensor 1000 may be reduced, and thus, the image sensor 1000 having higher resolution may be provided. The image sensor 1000 according to the example embodiment may form a camera module along with a module lens of various functions and may be utilized in various electronic devices.

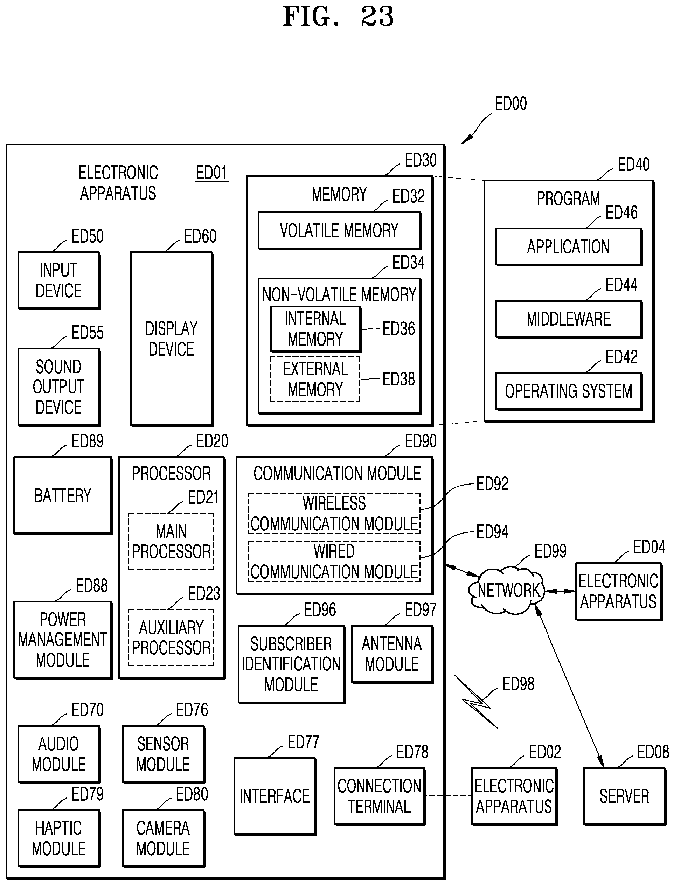

FIG. 23 is a block diagram showing an example of an electronic apparatus ED01 including an image sensor 1000. Referring to FIG. 23, in a network environment ED00, the electronic apparatus ED01 may communicate with another electronic apparatus ED02 via a first network ED98 (short-range wireless communication network, etc.), or may communicate with another electronic apparatus ED04 and/or a server ED08 via a second network ED99 (long-range wireless communication network, etc.) The electronic apparatus ED01 may communicate with the electronic apparatus ED04 via the server ED08. The electronic apparatus ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic apparatus ED01, some (display device ED60, etc.) of the elements may be omitted or another element may be added. Some of the elements may be configured as one integrated circuit. For example, the sensor module ED76 (a fingerprint sensor, an iris sensor, an illuminance sensor, etc.) may be embedded and implemented in the display device ED60 (display, etc.).

The processor ED20 may control one or more elements (hardware, software elements, etc.) of the electronic apparatus ED01 connected to the processor ED20 by executing software (program ED40, etc.), and may perform various data processes or operations. As a part of the data processing or operations, the processor ED20 may load a command and/or data received from another element (sensor module ED76, communication module ED90, etc.) to a volatile memory ED32, may process the command and/or data stored in the volatile memory ED32, and may store result data in a non-volatile memory ED34. The processor ED20 may include a main processor ED21 (central processing unit, application processor, etc.) and an auxiliary processor ED23 (graphic processing unit, image signal processor, sensor hub processor, communication processor, etc.) that may be operated independently from or along with the main processor ED21. The auxiliary processor ED23 may use less power than that of the main processor ED21, and may perform specified functions.

The auxiliary processor ED23, on behalf of the main processor ED21 while the main processor ED21 is in an inactive state (sleep state) or along with the main processor ED21 while the main processor ED21 is in an active state (application executed state), may control functions and/or states related to some (display device ED60, sensor module ED76, communication module ED90, etc.) of the elements in the electronic apparatus ED01. The auxiliary processor ED23 (image signal processor, communication processor, etc.) may be implemented as a part of another element (camera module ED80, communication module ED90, etc.) that is functionally related thereto.

The memory ED30 may store various data required by the elements (processor ED20, sensor module ED76, etc.) of the electronic apparatus ED01. The data may include, for example, input data and/or output data about software (program ED40, etc.) and commands related thereto. The memory ED30 may include the volatile memory ED32 and/or the non-volatile memory ED34.

The program ED40 may be stored as software in the memory ED30, and may include an operation system ED42, middleware ED44, and/or an application ED46.

The input device ED50 may receive commands and/or data to be used in the elements (processor ED20, etc.) of the electronic apparatus ED01, from outside (user, etc.) of the electronic apparatus ED01. The input device ED50 may include a microphone, a mouse, a keyboard, and/or a digital pen (stylus pen).

The sound output device ED55 may output a sound signal to outside of the electronic apparatus ED01. The sound output device ED55 may include a speaker and/or a receiver. The speaker may be used for a general purpose such as multimedia reproduction or record play, and the receiver may be used to receive a call. The receiver may be coupled as a part of the speaker or may be implemented as an independent device.

The display device ED60 may provide visual information to outside of the electronic apparatus ED01. The display device ED60 may include a display, a hologram device, or a projector, and a control circuit for controlling the corresponding device. The display device ED60 may include a touch circuitry set to sense a touch, and/or a sensor circuit (pressure sensor, etc.) that is set to measure a strength of a force generated by the touch.

The audio module ED70 may convert sound into an electrical signal or vice versa. The audio module ED 70 may acquire sound through the input device ED50, or may output sound via the sound output device ED55 and/or a speaker and/or a headphone of another electronic apparatus (electronic apparatus ED02, etc.) connected directly or wirelessly to the electronic apparatus ED01.

The sensor module ED76 may sense an operating state (power, temperature, etc.) of the electronic apparatus ED01, or an outer environmental state (user state, etc.), and may generate an electrical signal and/or data value corresponding to the sensed state. The sensor module ED76 may include a gesture sensor, a gyro-sensor, a pressure sensor, a magnetic sensor, an acceleration sensor, a grip sensor, a proximity sensor, a color sensor, an infrared (IR) ray sensor, a vivo sensor, a temperature sensor, a humidity sensor, and/or an illuminance sensor.

The interface ED77 may support one or more designated protocols that may be used in order for the electronic apparatus ED01 to be directly or wirelessly connected to another electronic apparatus (electronic apparatus ED02, etc.) The interface ED77 may include a high-definition multimedia interface (HDMI), a universal serial bus (USB) interface, an SD card interface, and/or an audio interface.

The connection terminal ED78 may include a connector by which the electronic apparatus ED01 may be physically connected to another electronic apparatus (electronic apparatus ED02, etc.). The connection terminal ED78 may include an HDMI connector, a USB connector, an SD card connector, and/or an audio connector (headphone connector, etc.).

The haptic module ED79 may convert the electrical signal into a mechanical stimulation (vibration, motion, etc.) or an electric stimulation that the user may sense through a tactile or motion sensation. The haptic module ED79 may include a motor, a piezoelectric device, and/or an electric stimulus device.

The camera module ED80 may capture a still image and a video. The camera module ED80 may include a lens assembly including one or more lenses, the image sensor 1000 of FIG. 1, image signal processors, and/or flashes. The lens assembly included in the camera module ED80 may collect light emitted from an object that is an object to be captured.

The power management module ED88 may manage the power supplied to the electronic apparatus ED01. The power management module ED88 may be implemented as a part of a power management integrated circuit (PMIC).

The battery ED89 may supply electric power to components of the electronic apparatus ED01. The battery ED89 may include a primary battery that is not rechargeable, a secondary battery that is rechargeable, and/or a fuel cell.

The communication module ED90 may support the establishment of a direct (wired) communication channel and/or a wireless communication channel between the electronic apparatus ED01 and another electronic apparatus (electronic apparatus ED02, electronic apparatus ED04, server ED08, etc.), and execution of communication through the established communication channel. The communication module ED90 may be operated independently from the processor ED20 (application processor, etc.), and may include one or more communication processors that support the direct communication and/or the wireless communication. The communication module ED90 may include a wireless communication module ED92 (cellular communication module, a short-range wireless communication module, a global navigation satellite system (GNSS) communication module) and/or a wired communication module ED94 (local area network (LAN) communication module, a power line communication module, etc.). From among the communication modules, a corresponding communication module may communicate with another electronic apparatus via a first network ED09 (short-range communication network such as Bluetooth, WiFi direct, or infrared data association (IrDA)) or a second network ED99 (long-range communication network such as a cellular network, Internet, or computer network (LAN, WAN, etc.)). Such above various kinds of communication modules may be integrated as one element (single chip, etc.) or may be implemented as a plurality of elements (a plurality of chips) separately from one another. The wireless communication module ED92 may identify and authenticate the electronic apparatus ED01 in a communication network such as the first network ED98 and/or the second network ED99 by using subscriber information (international mobile subscriber identifier (IMSI), etc.) stored in the subscriber identification module ED96.

The antenna module ED97 may transmit or receive the signal and/or power to/from outside (another electronic apparatus, etc.). An antenna may include a radiator formed as a conductive pattern formed on a substrate (PCB, etc.). The antenna module ED97 may include one or more antennas. When the antenna module ED97 includes a plurality of antennas, from among the plurality of antennas, an antenna that is suitable for the communication type used in the communication network such as the first network ED98 and/or the second network ED99 may be selected by the communication module ED90. The signal and/or the power may be transmitted between the communication module ED90 and another electronic apparatus via the selected antenna. Another component (RFIC, etc.) other than the antenna may be included as a part of the antenna module ED97.

Some of the elements may be connected to one another via the communication method among the peripheral devices (bus, general purpose input and output (GPIO), serial peripheral interface (SPI), mobile industry processor interface (MIPI), etc.) and may exchange signals (commands, data, etc.).

The command or data may be transmitted or received between the electronic apparatus ED01 and the external electronic apparatus ED04 via the server ED08 connected to the second network ED99. Other electronic apparatuses ED02 and ED04 may be the devices that are the same as or different kinds from the electronic apparatus ED01. All or some of the operations executed in the electronic apparatus ED01 may be executed in one or more devices among the other electronic apparatuses ED02, ED04, and ED08. For example, when the electronic apparatus ED01 has to perform a certain function or service, the electronic apparatus ED01 may request one or more other electronic apparatuses to perform some or entire function or service, instead of executing the function or service by itself. One or more electronic apparatuses receiving the request execute an additional function or service related to the request and may transfer a result of the execution to the electronic apparatus ED01. To do this, for example, a cloud computing, a distributed computing, or a client-server computing technique may be used.

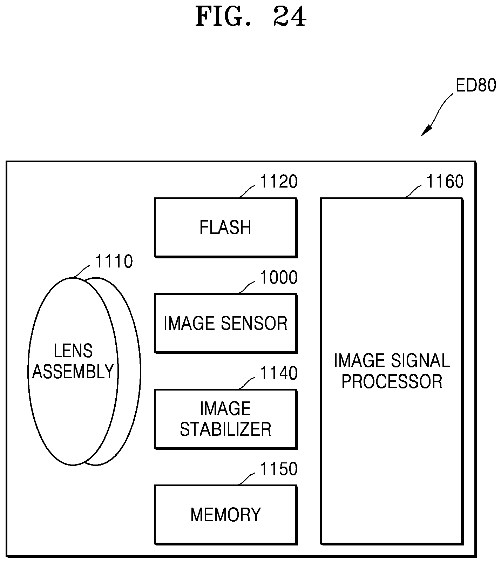

FIG. 24 is a block diagram showing an example of the camera module ED80 included in the electronic apparatus ED01 of FIG. 23. Referring to FIG. 24, the camera module ED80 may include a lens assembly 1110, a flash 1120, an image sensor 1000, an image stabilizer 1140, a memory 1150 (buffer memory, etc.), and/or an image signal processor 1160. The lens assembly 1110 may collect light emitted from an object that is to be captured. The camera module ED80 may include a plurality of lens assemblies 1110, and in this case, the camera module ED80 may include a dual camera module, a 360-degree camera, or a spherical camera. Some of the plurality of lens assemblies 1110 may have the same lens properties (viewing angle, focal length, auto-focus, F number, optical zoom, etc.) or different lens properties. The lens assembly 1110 may include a wide-angle lens or a telephoto lens.

The flash 1120 may emit light that is used to strengthen the light emitted or reflected from the object. The flash 1120 may emit visible light or infrared-ray light. The flash 1120 may include one or more light-emitting diodes (red-green-blue (RGB)) LED, white LED, infrared LED, ultraviolet LED, etc.), and/or a Xenon lamp. The image sensor 1000 may be the image sensor described above with reference to FIG. 1, and converts the light emitted or reflected from the object and transferred through the lens assembly 1110 into an electrical signal to obtain an image corresponding to the object.

The image stabilizer 1140, in response to a motion of the camera module ED80 or the electronic apparatus 1101 including the camera module ED80, moves one or more lenses included in the lens assembly 1110 or the image sensor 1000 in a certain direction or controls the operating characteristics of the image sensor 1000 (adjusting of a read-out timing, etc.) in order to compensate for a negative influence of the motion. The image stabilizer 1140 may sense the movement of the camera module ED80 or the electronic apparatus ED01 by using a gyro sensor (not shown) or an acceleration sensor (not shown) disposed in or out of the camera module ED80. The image stabilizer 1140 may be implemented as an optical type.

The memory 1150 may store some or entire data of the image obtained through the image sensor 1000 for next image processing operation. For example, when a plurality of images are obtained at a high speed, obtained original data (Bayer-patterned data, high-resolution data, etc.) is stored in the memory 1150, and a low-resolution image is only displayed. Then, original data of a selected image (user selection, etc.) may be transferred to the image signal processor 1160. The memory 1150 may be integrated with the memory ED30 of the electronic apparatus ED01, or may include an additional memory that is operated independently.

The image signal processor 1160 may perform image treatment on the image obtained through the image sensor 1000 or the image data stored in the memory 1150. The image treatments may include a depth map generation, a three-dimensional modeling, a panorama generation, extraction of features, an image combination, and/or an image compensation (noise reduction, resolution adjustment, brightness adjustment, blurring, sharpening, softening, etc.). The image signal processor 1160 may perform controlling (exposure time control, read-out timing control, etc.) of the elements (image sensor 1000, etc.) included in the camera module ED80. Also, the image signal processor 1160 may generate a full-color image by executing the above demosaic algorithm. For example, when the demosaic algorithm is executed to generate the full-color image, the image signal processor 1160 may reconstruct most of the spatial resolution information by using an image signal of a green channel or yellow channel having high spatial sampling rate.

The image processed by the image signal processor 1160 may be stored again in the memory 1150 for additional process, or may be provided to an external element of the camera module ED80 (e.g., the memory ED30, the display device ED60, the electronic apparatus ED02, the electronic apparatus ED04, the server ED08, etc.). The image signal processor 1160 may be integrated with the processor ED20, or may be configured as an additional processor that is independently operated from the processor ED20. When the image signal processor 1160 is configured as an additional processor separately from the processor ED20, the image processed by the image signal processor 1160 undergoes through an additional image treatment by the processor ED20 and then may be displayed on the display device ED60.

Also, the image signal processor 1160 may receive two output signals independently from the adjacent photosensitive cells in each pixel or sub-pixel of the image sensor 1000, and may generate an auto-focusing signal from a difference between the two output signals. The image signal processor 1160 may control the lens assembly 1110 so that the focus of the lens assembly 1110 may be accurately formed on the surface of the image sensor 1000 based on the auto-focusing signal.

The electronic apparatus ED01 may further include one or a plurality of camera modules having different properties or functions. The camera module may include elements similar to those of the camera module ED80 of FIG. 24, and the image sensor included in the camera module may be implemented as a CCD sensor and/or a CMOS sensor and may include one or a plurality of sensors selected from the image sensors having different properties, such as an RGB sensor, a black and white (BW) sensor, an IR sensor, or a UV sensor. In this case, one of the plurality of camera modules ED80 may include a wide-angle camera and another camera module ED80 may include a telephoto camera. Similarly, one of the plurality of camera modules ED80 may include a front camera and another camera module ED80 may include a rear camera.

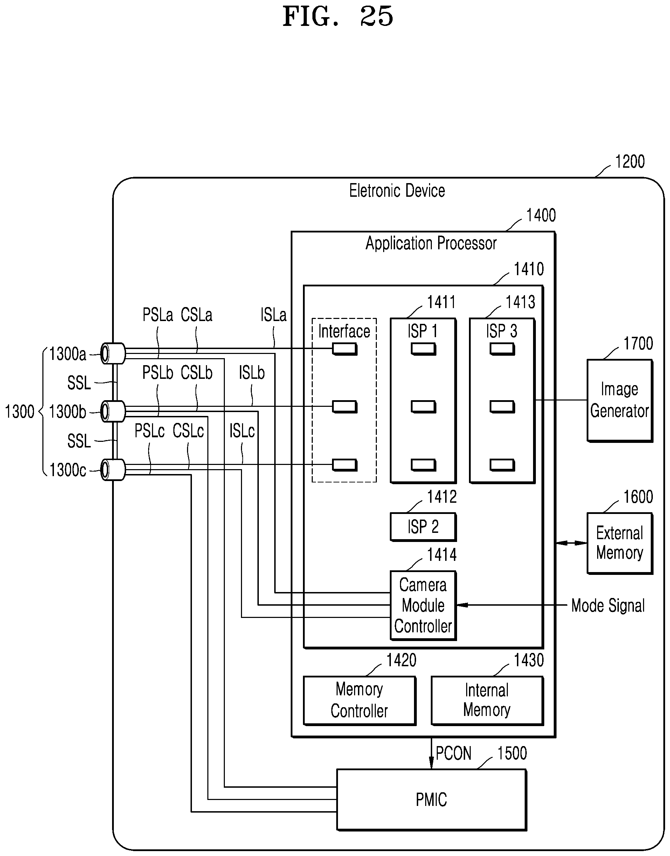

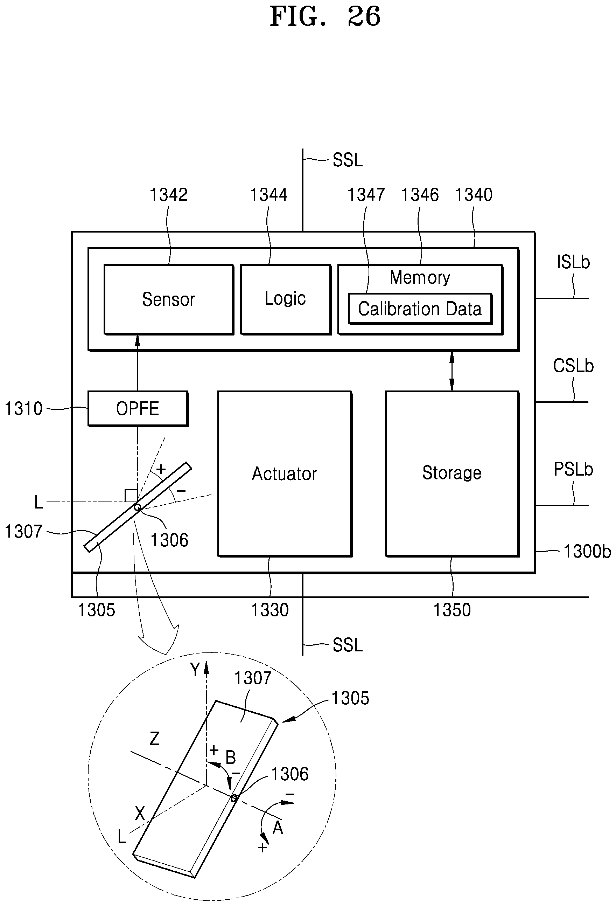

FIG. 25 is a block diagram of an electronic device 1200 including a multi-camera module, and FIG. 26 is a detailed block diagram of the camera module in the electronic device shown in FIG. 25.

Referring to FIG. 25, the electronic device 1200 may include a camera module group 1300, an application processor 1400, a power management integrated circuit (PMIC) 1500, an external memory 1600, and an image generator 1700.

The camera module group 1300 may include a plurality of camera modules 1300a, 1300b, and 1300c. Although the drawings show an example in which three camera modules 1300a, 1300b, and 1300c are arranged, one or more embodiments are not limited thereto. In some embodiments, the camera module group 1300 may be modified to include only two camera modules. Also, in some embodiments, the camera module group 1300 may be modified to include n (n is 4 or greater natural number) camera modules.

Hereinafter, detailed configuration of one camera module 1300b is described in detail below with reference to FIG. 26, but the description provided below may be also applied to the other camera modules 1300a and 1300c according to the example embodiments.

Referring to FIG. 26, the camera module 1300b may include a prism 1305, an optical path folding element (OPFE) 1310, an actuator 1330, an image sensing device 1340, and a storage unit 1350.

The prism 1305 may include a reflecting surface 1307 having a light-reflecting material and may deform a path of light L incident from outside.

In some embodiments, the prism 1305 may change the path of the light L incident in the first direction (X-direction) into a second direction (Y-direction) that is perpendicular to the first direction (X-direction). Also, the prism 1305 may rotate the reflecting surface 1307 having the light-reflecting material about a center axis 1106 in a direction A, or about the center axis 1306 in a direction B so that the path of the light L incident in the first direction (X-direction) may be changed to the second direction (Y-direction) perpendicular to the first direction (X-direction). Here, the OPFE 1310 may also move in the third direction (Z-direction) that is perpendicular to the first direction (X-direction) and the second direction (Y-direction).

In some embodiments, as shown in the drawings, the maximum rotation angle of the prism 1305 in the direction A is 15° or less in the positive A direction and is greater than 15° in the negative A direction, but embodiments are not limited thereto.

In some embodiments, the prism 1305 may be moved by the angle of about 20°, or between 10° to 20° or 15° to 20° in the positive or negative B direction. Here, the moving angle is the same in the positive or negative B direction, or may be similar within a range of about 1 °.

In some embodiments, the prism 1305 may move the reflecting surface 1307 of the light-reflective material in the third direction (e.g., Z direction) that is parallel to the direction in which the center axis 1306 extends.

The OPFE 1310 may include, for example, optical lenses formed as m groups (here, m is a natural number). Here, m lenses move in the second direction (Y-direction) and may change an optical zoom ratio of the camera module 1300b. For example, when a basic optical zoom ratio of the camera module 1300b is Z and m optical lenses included in the OPFE 1310 move, the optical zoom ratio of the camera module 1300b may be changed to 3Z, 5Z, or 10Z or greater.

The actuator 1330 may move the OPFE 1310 or the optical lens (hereinafter, referred to as optical lens) to a certain position. For example, the actuator 1330 may adjust the position of the optical lens so that the image sensor 1342 may be located at a focal length of the optical lens for exact sensing operation.

An image sensing device 1340 may include the image sensor 1342, a control logic 1344, and a memory 1346. The image sensor 1342 may sense an image of a sensing target by using the light L provided through the optical lens. The control logic 1344 may control the overall operation of the camera module 1300b. For example, the control logic 1344 may control the operations of the camera module 1300b according to a control signal provided through a control signal line CSLb.

For example, the image sensor 1342 may include the color separating lens array or the nano-photonic lens array described above. The image sensor 1342 may receive more signals separated according to wavelengths in each pixel by using the color separating lens array based on the nano-structures. Due to the above effects, the optical intensity required to generate high quality images of high resolution and under the low illuminance may be secured.

The memory 1346 may store information that is necessary for the operation of the camera module 1300b, e.g., calibration data 1347. The calibration data 1347 may include information that is necessary to generate image data by using the light L provided from outside through the camera module 1300b. The calibration data 1347 may include, for example, information about the degree of rotation described above, information about the focal length, information about an optical axis, etc. When the camera module 1300b is implemented in the form of a multi-state camera of which the focal length is changed according to the position of the optical lens, the calibration data 1347 may include information related to focal length values of the optical lens according to each position (or state) and auto-focusing.

The storage unit 1350 may store image data sensed through the image sensor 1342. The storage unit 1350 may be disposed out of the image sensing device 1340 and may be stacked with a sensor chip included in the image sensing device 1340. In some embodiments, the storage unit 1350 may be implemented as electrically erasable programmable read-only memory (EEPROM), but one or more embodiments are not limited thereto.

Referring to FIGS. 25 and 26, in some embodiments, each of the plurality of camera modules 1300a, 1300b, and 1300c may include the actuator 1330. Accordingly, each of the plurality of camera modules 1300a, 1300b, and 1300c may include the calibration data 1347 that is the same as or different from the others, according to the operation of the actuator 1330 included therein.

In some embodiments, one (for example, 1300b) of the plurality of camera modules 1300a, 1300b, and 1300c may be a camera module in a folded lens type including the prism 1305 and the OPFE 1310 described above, and the other camera modules (for example, 1300a and 1300c) may be vertical type camera modules not including the prism 1305 and the OPFE 1310. However, the disclosure is not limited thereto.

In some embodiments, one (for example, 1300c) of the plurality of camera modules 1300a, 1300b, and 1300c may be a depth camera of a vertical type, which extracts depth information by using infrared ray (IR).

In some embodiments, at least two camera modules (e.g., 1300a and 1300b) from among the plurality of camera module 1300a, 1300b, and 1300c may have different fields of view. In this case, for example, the optical lenses of the at least two camera modules (e.g., 1300a and 1300b) from among the plurality of camera modules 1300a, 1300b, and 1300c may be different from each other, but one or more embodiments are not limited thereto.

Also, in some embodiments, the plurality of camera modules 1300a, 1300b, and 1300c may have different fields of view from one another. In this case, the optical lenses respectively included in the plurality of camera modules 1300a, 1300b, and 1300c may be different from one another, but the inventive concept is not limited thereto.

In some embodiments, the plurality of camera modules 1300a, 1300b, and 1300c may be physically isolated from one another. That is, the sensing region of one image sensor 1342 may not be divided and used by the plurality of camera modules 1300a, 1300b, and 1300c, but the plurality of camera modules 1300a, 1300b, and 1300c may each have an independent image sensor 1342 provided therein.

Referring back to FIG. 25, the application processor 1400 may include an image processing device 1410, a memory controller 1420, and an internal memory 1430. The application processor 1400 may be separately implemented from the plurality of camera modules 1300a, 1300b, and 1300c. For example, the application processor 1400 and the plurality of camera modules 1300a, 1300b, and 1300c may be separately implemented as separate semiconductor chips.

The image processing device 1410 may include a plurality of image processors 1411, 1412, and 1413, and a camera module controller 1414.

The image data generated by each of the camera modules 1300a, 1300b, and 1300c may be provided to the image processing device 1410 via separate image signal lines, respectively. The image data transfer may be carried out by using a camera serial interface (CSI) based on a mobile industry processor interface (MIPI), for example, but is not limited thereto.

The image data transferred to the image processing device 1410 may be stored in an external memory 1600 before being transferred to the image processors 1411 and 1412. The image data stored in the external memory 1600 may be provided to the image processor 1411 and/or the image processor 1412. The image processor 1411 may correct the image data in order to generate video. The image processor 1412 may correct the image data in order to generate still images. For example, the image processors 1411 and 1412 may perform a pre-processing operation such as a color calibration, a gamma calibration on the image data.

The image processor 1411 may include sub-processors. When the number of sub-processors is equal to the number of camera modules 1300a, 1300b, and 1300c, each of the sub-processors may process the image data provided from one camera module. When the number of sub-processors is less than the number of camera modules 1300a, 1300b, and 1300c, at least one of the sub-processors may process the image data provided from a plurality of camera module by using a timing-sharing process. The image data processed by the image processor 1411 and/or the image processor 1412 may be stored in the external memory 1600 before being transferred to the image processor 1413. The image data stored in the external memory 1600 may be transferred to the image processor 1412. The image processor 1412 may perform a post-processing operation such as a noise calibration, a sharpen calibration, etc. on the image data.

The image data processed in the image processor 1413 may be provided to the image generator 1700. The image generator 1700 may generate a final image by using the image data provided from the image processor 1413 according to image generating information or a mode signal.

In detail, the image generator 1700 may generate by merging at least parts of the image data generated by the camera modules 1300a, 1300b, and 1300c having different fields of view, according to image generating information or the mode signal. Also, the image generator 1700 may generate the output image by selecting one of pieces of image data generated by the camera modules 1300a, 1300b, and 1300c having different fields of view, according to image generating information or the mode signal.

In some embodiments, the image generating information may include a zoom signal or a zoom factor. Also, in some embodiments, the mode signal may be, for example, a signal based on a mode selected by a user.

When the image generating information is a zoom signal (zoom factor) and the camera modules 1300a, 1300b, and 1300c have different fields of view (angles of view) from one another, the image generator 1700 may perform different operations according to the kind of zoom signal. For example, when the zoom signal is a first signal, the image data output from the camera module 1300a is merged with the image data output from the camera module 1300c, and then, the output image may be generated by using the merged image signal and the image data output from the camera module 1300b and not used in the merge. When the zoom signal is a second signal that is different from the first signal, the image generator 1700 may not perform the image data merging, and then, may generate the output image by selecting one piece of the image data output respectively from the camera modules 1300a, 1300b, and 1300c. However, one or more embodiments are not limited thereto, and the method of processing the image data may be modified as necessary.

The camera module controller 1414 may provide each of the camera modules 1300a, 1300b, and 1300c with a control signal. The control signals generated by the camera module controller 1414 may be provided to corresponding camera modules 1300a, 1300b, and 1300c via control signal lines CSLa, CSLb, and CSLc separated from one another.

In some embodiments, the control signal provided to the plurality of camera modules 1300a, 1300b, and 1300c from the camera module controller 1414 may include mode information according to the mode signal. The plurality of camera modules 1300a, 1300b, and 1300c may operate in a first operation mode and a second operation mode in relation to the sensing speed, based on the mode information.

In the first operation mode, the plurality of camera modules 1300a, 1300b, and 1300c may generate the image signal at a first speed (for example, generating an image signal of a first frame rate), encodes the image signal at a second speed that is faster than the first speed (for example, encoding the image signal of a second frame rate that is greater than the first frame rate), and transfers the encoded image signal to the application processor 1400. Here, the second speed may be 30 times faster than the first speed or less.

The application processor 1400 may store the received image signal, that is, the encoded mage signal, in the internal memory 1430 provided therein or the external memory 1600 outside the application processor 1400, and after that, reads and decodes the encoded signal from the internal memory 1430 or the external memory 1600, and may display the image data generated based on the decoded image signal. For example, the image processors 1411 and 1412 in the image processing device 1410 may perform decoding, and may perform image processing on the decoded image signals.

In the second operation mode, the plurality of camera modules 1300a, 1300b, and 1300c generates an image signal at a third speed that is slower than the first speed (for example, generating the image signal of a third frame rate that is lower than the first frame rate), and may transfer the image signal to the application processor 1400. The image signal provided to the application processor 1400 may be a signal that is not encoded. The application processor 1400 may perform the image processing of the received image signal or store the image signal in the internal memory 1430 or the external memory 1600.

The PMIC 1500 may supply the power, for example, the power voltage, to each of the plurality of camera modules 1300a, 1300b, and 1300c. For example, the PMIC 1500 may supply the first power to the camera module 1300a via a power signal line PSLa, the second power to the camera module 1300b via a power signal line PSLb, and the third power to the camera module 1300c via a power signal line PSLc, under the control of the application processor 1400.

The PMIC 1500 may generate the power corresponding to each of the plurality of camera modules 1300a, 1300b, and 1300c and may adjust the power level, in response to a power control signal PCON from the application processor 1400. The power control signal PCON may include a power adjusting signal for each operation mode of the plurality of camera modules 1300a, 1300b, and 1300c. For example, the operation mode may include a low power mode, and the power control signal PCON may include information about the camera module operating in the low-power mode and set power level. The levels of the power provided to the plurality of camera modules 1300a, 1300b, and 1300c may be equal to or different from each other. Also, the power level may be dynamically changed.

It should be understood that example embodiments described herein should be considered in a descriptive sense only and not for purposes of limitation. Descriptions of features or aspects within each example embodiment should typically be considered as available for other similar features or aspects in other embodiments. While example embodiments have been described with reference to the figures, it will be understood by those of ordinary skill in the art that various changes in form and details may be made therein without departing from the scope as defined by the following claims and their equivalents.

## Claims

1. An image sensor comprising:
a sensor substrate comprising a plurality of pixels configured to sense light; and
a nano-photonic lens array configured to separate incident light based on color and condense the separated incident light onto the plurality of pixels,
wherein the nano-photonic lens array comprises a plurality of supercells that are periodically two-dimensionally disposed, the plurality of supercells comprising first unit patterns and second unit patterns, and the first unit patterns and the second unit patterns respectively comprising a plurality of pixel corresponding regions corresponding to the plurality of pixels,
wherein each of the plurality of pixel corresponding regions comprises a plurality of nano-structures configured to separate the incident light based on color and condense the incident light onto the plurality of pixels, and
wherein a cross-sectional size or a cross-sectional shape of a first nano-structure among the plurality of nano-structures included in the first unit patterns is different from a cross-sectional size or a cross-sectional shape of a second nano-structure, among the plurality of nano-structures in the second unit pattern, at a position corresponding to the first nano-structure.

2. The image sensor of claim 1, wherein a first cross-sectional size of the first nano-structure included in the first unit pattern is different from a second cross-sectional size of the second nano-structure included in the second unit pattern, and optionally wherein the first cross-sectional size and the second cross-sectional size are integer multiples of a minimum unit size.

3. The image sensor of claim 2, wherein the nano-photonic lens array comprises a first section, a second section, and a third section between the first section and the second section, and
wherein the first section comprises the first unit patterns, the second section comprises the second unit patterns, and the third section comprises the plurality of supercells, and optionally wherein, in each of the plurality of supercells, the first unit patterns, and the second unit patterns are in an NxM array, where at least one of N and M is an integer greater than or equal to 2.

4. The image sensor of claim 3, wherein the nano-photonic lens array further comprises a fourth section between the third section and the second section,
wherein the plurality of supercells comprise a plurality of first supercells periodically two-dimensionally disposed in the third section and a plurality of second supercells periodically two-dimensionally disposed in the fourth section, and
wherein a ratio between the first unit patterns and the second unit patterns included in each of the plurality of first supercells are different from a ratio between the first unit patterns and the second unit patterns in each of the plurality of second supercells, and optionally wherein the first section, the second section, the third section, and the fourth section are disposed in concentric circles.

5. The image sensor of claim 4, wherein, in each of the plurality of first supercells and the plurality of second supercells, the first unit patterns and the second unit patterns are disposed in a 2x2 array, and
wherein each of the plurality of first supercells comprises three first unit patterns and one second unit pattern, and each of the plurality of second supercells comprises two first unit patterns and two second unit patterns, and optionally wherein:
the plurality of first supercells included in the third section comprise a first array and a second array, wherein the arrangement of the first unit patterns and the second unit patterns in the first array is different from the arrangement of the first unit patterns and the second unit patterns in the second array; and
the plurality of second supercells included in the fourth section comprise a third array and a fourth array, wherein the arrangement of the first unit patterns and the second unit patterns in the third array is different from the arrangement of the first unit patterns and the second unit patterns in the fourth array.

6. The image sensor of claim 4 or 5 , wherein the nano-photonic lens array further comprises a fifth section between the fourth section and the second section,
wherein the plurality of supercells comprise a plurality of third supercells periodically and two-dimensionally disposed in the fifth section, and
wherein a ratio between the first unit patterns and the second unit patterns in each of the plurality of third supercells are different from the ratio between the first unit patterns and the second unit patterns in each of the plurality of first supercells and each of the plurality of second supercells.

7. The image sensor of claim 6, wherein a ratio of the first unit patterns is reduced and a ratio of the second unit patterns is increased sequentially from the first section to the third section, the fourth section, the fifth section, and the second section.

8. The image sensor of claim 6, wherein, in each of the plurality of first supercells, the plurality of second supercells, and the plurality of third supercells, the first unit patterns and the second unit patterns are disposed in a 2x2 array, and
wherein each of the plurality of first supercells comprises three first unit patterns and one second unit pattern, each of the plurality of second supercells comprises two first unit patterns and two second unit patterns, and each of the plurality of third supercells comprises one first unit pattern and three second unit patterns.

9. The image sensor of any of claims 6 to 8 , wherein the plurality of supercells in at least one of the third section, the fourth section, and the fifth section respectively comprises a plurality of unit patterns disposed in an N1xM1 array, the plurality of supercells in at least a section different from the third section, the fourth section, and the fifth section respectively comprises a plurality of unit patterns disposed in an N2xM2 array, where N1 and N2 are positive integers that are different from each other or M1 and M2 are positive integers that are different from each other.

10. The image sensor of any preceding claim, wherein the first unit patterns and the second unit patterns comprise third nano-structures having cross-sectional sizes or cross-sectional shapes that are equal to or different from the cross-sectional sizes or cross-sectional shapes of the first nano-structures and the second nano-structures.

11. The image sensor of claim 10, wherein the nano-photonic lens array further comprises fourth nano-structures having cross-sectional sizes or cross-sectional shapes that are equal to or different from the cross-sectional sizes or the cross-sectional shapes of the first nano-structures and second nano-structures and are different from the cross-sectional sizes or the cross-sectional shapes of the third nano-structures.

12. The image sensor of claim 11, wherein a first cross-sectional size of the first nano-structure is different from a second cross-sectional size of the second nano-structure, and
wherein a third cross-sectional size of the third nano-structure is equal to or different from the first cross-sectional size and the second cross-sectional size and a fourth cross-sectional size of the fourth nano-structure is equal to or different from the first cross-sectional size and the second cross-sectional size and different from the third cross-sectional size.

13. The image sensor of claim 11 or 12, wherein the nano-photonic lens array further comprises third unit patterns and fourth unit patterns, the third unit patterns respectively comprises the first nano-structures and the fourth nano-structures, and the fourth unit patterns respectively comprises the second nano-structure and the fourth nano-structure, and optionally wherein the nano-photonic lens array further comprises a plurality of supercells in which unit patterns selected from the first unit patterns, the second unit patterns, the third unit patterns, and the fourth unit patterns are arranged in an NxM array, where at least one of N and M is an integer greater than or equal to 2.

14. The image sensor of any preceding claim, wherein the plurality of pixels comprise a plurality of unit pixel patterns respectively comprising a first pixel, a second pixel, a third pixel, and a fourth pixel,
wherein the plurality of pixel corresponding regions included in each of the first unit patterns and the second unit patterns comprise a first pixel corresponding region corresponding to the first pixel, a second pixel corresponding region corresponding to the second pixel, a third pixel corresponding region corresponding to the third pixel, and a fourth pixel corresponding region corresponding to the fourth pixel, and
wherein a cross-sectional size, a cross-sectional shape, and a height of each of the plurality of nano-structures and an arrangement period and an arrangement shape of the plurality of nano-structures are determined such that, in incident light incident on the first pixel corresponding region, the second pixel corresponding region, the third pixel corresponding region, and the fourth pixel corresponding region, light of a first wavelength band is separated and condensed onto the first pixel, light of a second wavelength band different from the first wavelength band is separated and condensed onto the second pixel and the third pixel, and light of a third wavelength band different from the first wavelength band and the second wavelength band is separated and condensed onto the fourth pixel.

15. An electronic apparatus comprising:
a lens assembly configured to form an optical image of a subject;
an image sensor according to any preceding claims configured to convert the optical image formed by the lens assembly into an electrical signal; and
a processor configured to process a signal generated by the image sensor.
